# EUROPEAN PATENT SPECIFICATION

(11) **EP 4 280 285 B1**
(45) Date of publication and mention of the grant of the patent: **29.04.2026**
(21) Application number: 23710655.4
(22) Date of filing: 16.03.2023
(51) Int. Cl.: H10F 39/00, H04N 23/56, H04N 23/57, H01L 23/552, H04N 23/90, H04N 25/705, H04M 1/02

(54) **SHIELDING STRUCTURE FOR REDUCING CROSSTALK OF OPTICAL SENSOR AND METHOD FOR MANUFACTURING SAME**
ABSCHIRMSTRUKTUR ZUR VERRINGERUNG DES ÜBERSPRECHENS EINES OPTISCHEN SENSORS UND VERFAHREN ZUR HERSTELLUNG DAVON
STRUCTURE DE BLINDAGE POUR RÉDUIRE LA DIAPHONIE D'UN CAPTEUR OPTIQUE ET SON PROCÉDÉ DE FABRICATION

(30) Priority: 29.03.2022 KR 20220039120; 06.05.2022 KR 20220056100
(43) Date of publication of application: 22.11.2023
(73) Proprietor: Samsung Electronics Co., Ltd., Suwon-Si, Gyeonggi-do 16677 (KR)
(72) Inventor: CHOI, Gwangho, Suwon-si Gyeonggi-do 16677 (KR); PARK, Hyein, Suwon-si Gyeonggi-do 16677 (KR); LIM, Jaedeok, Suwon-si Gyeonggi-do 16677 (KR)
(74) Representative: Nederlandsch Octrooibureau
(86) International application number: PCT/KR2023/003514
(87) International publication number: WO 2023/191358

(56) References cited:
- EP-A2- 0 756 191
- CN-A- 118 974 933
- JP-A- 2012 119 448
- JP-A- 2020 129 630
- KR-A- 20210 091 237
- KR-B1- 100 267 522
- KR-B1- 101 456 971
- KR-B1- 101 456 971
- US-A1- 2020 373 359
- US-A1- 2021 219 470

## Description

### [Technical Field]

Various embodiments of the disclosure described herein relate to a shielding structure for reducing crosstalk of an optical sensor and a manufacturing method thereof.

### [Background Art]

As the degree of integration of an electronic device is raised and highspeed and high-capacity wireless communication is widely used, a single electronic device such as a mobile communication terminal may be equipped with various functions. The electronic device is made compact so that a user is able to conveniently carry the electronic device. As the electronic device is made compact, a mounting space in the electronic device for mounting various electronic parts may be insufficient.

The electronic device may include a large screen display to secure wide visibility and improve convenience of operation. The electronic device may include at least one sensor module in an inner space under the display disposed in the front direction or around a camera region disposed on a surface facing in a direction opposite to the front direction. The at least one sensor module may be an optical sensor using light and may include a light emitting unit and a light receiving unit. For example, the sensor module may include at least one of a proximity sensor, a UV sensor, an iris sensor, a camera module, an RGB sensor, and illuminance sensor, and/or a time of flight (TOF) sensor. Patent document KR 10-1456971, published on 4 November 2014, discloses a crosstalk prevention device of a motion sensor capable of preventing crosstalk that the light generated from a light emitting sensor is reflected from the inner boundary surface of a plastic material or the surface of a window glass and flows into a light receiving sensor. Patent document US 2020/0373359 A1, published on 26 November 2020, discloses a display panel comprising a lower display substrate that includes a plurality of light emitting elements, and an upper display substrate that includes a color control layer and is on the lower display substrate. Patent document EP 0756191A2, published on 29 January 1997, discloses a liquid crystal display apparatus including a liquid crystal panel for data display comprising a pair of oppositely disposed substrates and a liquid crystal dis posed between the substrates, a sheet of substantially transparent protection plate disposed opposite to and with a prescribed gap from a display surface of the liquid crystal panel for protecting the liquid crystal panel, and a polarizer sheet for selectively transmitting light having a plane of polarization in a prescribed direction dis posed on at least the display surface of the liquid crystal panel. Patent document US 2021/0219470 A1, published on 15 July 2021, discloses an electronic device including a shielding member for performing an electromagnetic interference (EMI) shielding function.

### [Disclosure]

### [Technical Problem]

As the electronic device is made compact, electronic parts, which are also called as "electronic components" or "electronic elements", in the electronic device may be disposed adjacent to each other. When the electronic parts are disposed adjacent to each other, electromagnetic waves emitted from some of the electronic parts may affect operations of the other electronic parts. To minimize the influence of electromagnetic waves on the electronic parts, the electronic device may include a shielding member for shielding the electromagnetic waves.

Recently, due to a small mounting space, a thin-film type shielding structure such as a conformal shield that meets compactness and lightness of the electronic device is increasingly used. The conformal shield may form a thin metal coating layer on a surface of a system in package (SiP) module including a sensor module (e.g., an optical sensor). To protect the sensor module from an external impact, an air gap, which is a buffer space, may be formed between a member, such as the display, which is disposed outside the conformal shield and a surface of the conformal shield. For example, the air gap of the conformal shield may be formed to be larger than that of a shield can that is another type of shielding structure. When the interval of the air gap is large, a portion of light generated by the light emitting unit may be easily received by the light receiving unit through the air gap, and therefore crosstalk, which is noise other than a signal, may be generated in the light receiving unit. A separate shielding member (e.g., a sponge) may be installed between the light emitting unit and the light receiving unit to reduce the crosstalk by blocking travel of light.

Various embodiments of the disclosure provide a shielding structure in which a diffuse reflection layer on a surface of a conformal shield prevents crosstalk by reducing the reflectance of light induced in an air gap between an optical sensor and an upper structure without a separate shielding member between a light source of the optical sensor and a light receiving unit.

However, the problems to be solved by the disclosure are not limited to the aforementioned problems and may be expanded in various ways without departing from the scope of the disclosure.

### [Technical Solution]

The invention is set out in the appended set of claims.

### [ Advantageous Effects]

The shielding structure according to the various embodiments of the disclosure may reduce the reflectance on the optical sensor and the shielding structure formed on the surface thereof to reduce crosstalk and improve a signal-to-noise ratio (SNR), thereby improving sensing accuracy of the optical sensor.

According to the various embodiments of the disclosure, the shielding structure may be formed by adding the diffuse reflection layer to the conformal shield. Accordingly, the shielding structure may shield optical and/or electromagnetic noise and may occupy a small mounting space in the electronic device, thereby meeting compactness and lightness of the electronic device. Furthermore, the shielding structure may be lower in cost than an existing shielding member and thus may achieve cost savings.

In addition, the disclosure may provide various effects that are directly or indirectly recognized.

### [ Description of Drawings]

FIG. 1 is a view illustrating an electronic device according to an embodiment.
FIG. 2 illustrates an exploded perspective view of the electronic device according to an embodiment.
FIG. 3 is a perspective view illustrating a state in which a shielding structure is applied to a sensor module according to an embodiment.
FIG. 4 illustrates a sectional view of an upper structure, the sensor module, and the shielding structure taken along line A-A' of FIG. 1 and a blowup of region B.
FIG. 5A illustrates a sectional view of a structure in which a shield can is installed over the sensor module.
FIG. 5B illustrates a sectional view of a structure in which a conformal shield is installed on the sensor module.
FIG. 5C illustrates a sectional view of a structure in which the conformal shield and a shielding member are installed on the sensor module.
FIG. 6 illustrates a sectional view of the shielding structure according to an embodiment.
FIG. 7 illustrates operations for forming the shielding structure according to an embodiment.
FIG. 8 illustrates a plan view of a diffuse reflection layer of the shielding structure according to an embodiment.
FIG. 9 illustrates a sectional view of the diffuse reflection layer taken along line D-D' of FIG. 8.
FIG. 10 illustrates a perspective view of a roller and a blowup of region C according to an embodiment.
FIG. 11 illustrates a sectional view of a printing surface of the roller taken along line E-E' of FIG. 10.
FIG. 12 illustrates a block diagram of an electronic device in a network environment according to various embodiments.
With regard to description of the drawings, identical or similar reference numerals may be used to refer to identical or similar components.

### [ Mode for Invention]

Hereinafter, various embodiments of the disclosure may be described with reference to accompanying drawings. Accordingly, those of ordinary skill in the art will recognize that modification, and/or alternative on the various embodiments described herein can be variously made without departing from the scope of the disclosure.

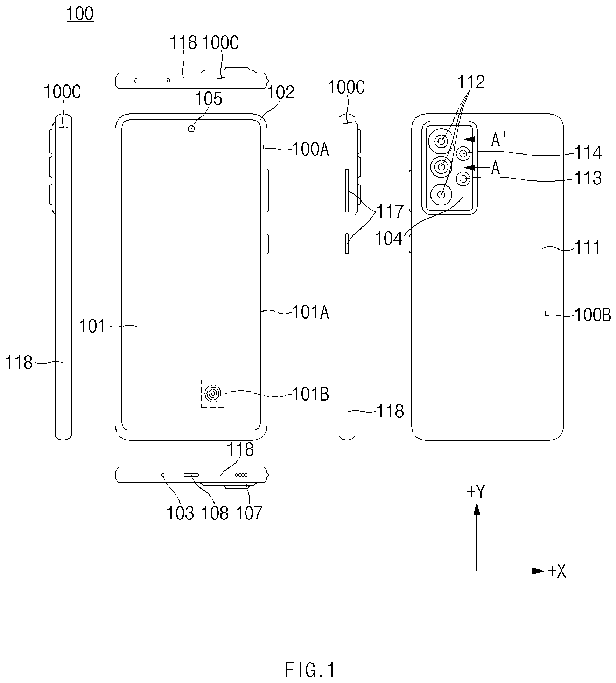

FIG. 1 is a view illustrating an electronic device according to an embodiment.

Referring to FIG. 1, the electronic device 100 according to an embodiment may include a housing that forms the exterior of the electronic device 100. For example, the housing may include a first surface (or, a front surface) 100A, a second surface (or, a rear surface) 100B, and a third surface (or, a side surface) 110C surrounding a space between the first surface 100A and the second surface 100B. In an embodiment, the housing may refer to a structure that forms at least a part of the first surface 100A, the second surface 100B, and/or the third surface 100C.

The electronic device 100 according to an embodiment may include a front plate 102 that is substantially transparent. In an embodiment, the front plate 102 may form at least a portion of the first surface 100A. In an embodiment, the front plate 102 may include, for example, a glass plate including various coating layers or a polymer plate, but is not limited thereto.

The electronic device 100 according to an embodiment may include a back plate 111 that is substantially opaque. In an embodiment, the back plate 111 may form at least a portion of the second surface 100B. In an embodiment, the back plate 111 may be formed of coated or colored glass, ceramic, a polymer, metal (e.g., aluminum, stainless steel (STS), or magnesium), or a combination of at least two of the aforementioned materials.

The electronic device 100 according to an embodiment may include a side bezel structure (or, a side member) 118. In an embodiment, the side bezel structure 118 may be coupled with the front plate 102 and/or the back plate 111 to form at least a portion of the third surface 100C of the electronic device 100. For example, the side bezel structure 118 may form the entire third surface 100C of the electronic device 100. In another example, the side bezel structure 118 may form the third surface 100C of the electronic device 100 together with the front plate 102 and/or the back plate 111.

In a case in which the third surface 100C of the electronic device 100 is partially formed by the front plate 102 and/or the back plate 111 unlike in the illustrated embodiment, the front plate 102 and/or the back plate 111 may include regions that curvedly and seamlessly extend from the periphery thereof toward the back plate 111 and/or the front plate 102. The extending regions of the front plate 102 and/or the back plate 111 may be located, for example, at opposite long edges of the electronic device 100, but are not limited by the above-described example.

In an embodiment, the side bezel structure 118 may include metal and/or a polymer. In an embodiment, the back plate 111 and the side bezel structure 118 may be integrally formed with each other and may include the same material (e.g., a metallic material such as aluminum), but are not limited thereto. For example, the back plate 111 and the side bezel structure 118 may be formed as separate components and/or may include different materials.

In an embodiment, the electronic device 100 may include at least one of a display 101, an audio module 103, 104, and 107, a sensor module (not illustrated), camera modules 105, 112, and 113, a Time of flight (TOF) sensor 114, key input devices 117, a light emitting element (not illustrated), and/or a connector hole 108. In another embodiment, the electronic device 100 may omit at least one component (e.g., the key input devices 117 or the light emitting element (not illustrated)) among the aforementioned components, or may additionally include other component(s).

In an embodiment, the display 101 may be visually exposed through most of the front plate 102. For example, at least a portion of the display 101 may be visible through the front plate 102 that forms the first surface 100A. In an embodiment, the display 101 may be disposed on a rear surface of the front plate 102.

In an embodiment, the shape of the outside edge of the display 101 may be formed to be substantially the same as the shape of the outside edge of the front plate 102 adjacent to the display 101. In an embodiment, the gap between the outside edge of the display 101 and the outside edge of the front plate 102 may be substantially constant to expand the area by which the display 101 is visually exposed.

In an embodiment, the display 101 (or, the first surface 100A of the electronic device 100) may include a screen display area 101A. In an embodiment, the display 101 may provide visual information to a user through the screen display area 101A. In the illustrated embodiment, the screen display area 101A is illustrated as being spaced apart from the outside edge of the first surface 100A and located in the first surface 100A when the first surface 100A is viewed from the front, but is not limited thereto. In another embodiment, when the first surface 100A is viewed from the front, at least a portion of the periphery of the screen display area 101A may substantially coincide with the periphery of the first surface 100A (or, the front plate 102).

In an embodiment, the screen display area 101A may include a sensing region 101B configured to obtain biometric information of the user. When the screen display area 101A includes the sensing region 101B, this may mean that at least a portion of the sensing region 101B overlaps the screen display area 101A. For example, the sensing region 101B may refer to a region capable of displaying visual information of the display 101 like the other regions of the screen display area 101A and additionally obtaining the user's biometric information (e.g., fingerprint). In another embodiment, the sensing region 101B may be formed on the key input devices 117.

In an embodiment, the display 101 may include a region where the first camera module 105 is located. In an embodiment, an opening may be formed in the region of the display 101, and the first camera module 105 (e.g., a punch hole camera) may be at least partially disposed in the opening to face toward the first surface 100A. In this case, the screen display area 101A may surround at least a portion of the periphery of the opening. In another embodiment, the first camera module 105 (e.g., an under display camera (UDC)) may be disposed under the display 101 to overlap the region of the display 101. In this case, the display 101 may provide visual information to the user through the region. Additionally, the first camera module 105 may obtain, through the region of the display 101, an image corresponding to a direction toward the first surface 100A.

In an embodiment, the display 101 may be combined with, or disposed adjacent to, touch detection circuitry, a pressure sensor capable of measuring the intensity (pressure) of a touch, and/or a digitizer for detecting a stylus pen of a magnetic type.

In an embodiment, the audio module 103, 104, and 107 may include the microphone holes 103 and 104 and the speaker hole 107.

In an embodiment, the microphone holes 103 and 104 may include the first microphone hole 103 formed in a partial region of the third surface 100C and the second microphone hole 104 formed in a partial region of the second surface 100B. A microphone (not illustrated) for obtaining external sound may be disposed in the microphone holes 103 and 104. The microphone may include a plurality of microphones to sense the direction of sound.

In an embodiment, the second microphone hole 104 formed in the partial region of the second surface 100B may be disposed adjacent to the camera modules 112 and 113. For example, the second microphone hole 104 may obtain sounds depending on operations of the camera modules 112 and 113. However, the disclosure is not limited thereto.

In an embodiment, the speaker hole 107 may include an external speaker hole 107 and a receiver hole for telephone call (not illustrated). The external speaker hole 107 may be formed in a portion of the third surface 100C of the electronic device 100. In another embodiment, the external speaker hole 107, together with the microphone hole 103, may be implemented as a single hole. Although not illustrated, the receiver hole for telephone call (not illustrated) may be formed in another portion of the third surface 100C. For example, the receiver hole for telephone call may be formed on the opposite side to the external speaker hole 107 on the third surface 100C. For example, based on FIG. 1, the external speaker hole 107 may be formed in the third surface 100C corresponding to a lower end portion of the electronic device 100, and the receiver hole for telephone call may be formed in the third surface 100C corresponding to an upper end portion of the electronic device 100. However, the disclosure is not limited thereto, and in another embodiment, the receiver hole for telephone call may be formed in a position rather than the third surface 100C. For example, the receiver hole for telephone call may be formed by a separation space between the front plate 102 (or, the display 101) and the side bezel structure 118.

The electronic device 100 may include at least one speaker (not illustrated) that is configured to output sound outside the housing through the external speaker hole 107 or the receiver hole for telephone call (not illustrated).

The sensor module (not illustrated) may generate an electrical signal or a data value that corresponds to an operational state inside the electronic device 100 or an environmental state external to the electronic device 100. For example, the sensor module may include at least one of a proximity sensor, an HRM sensor, a fingerprint sensor, a gesture sensor, a gyro sensor, an atmospheric pressure sensor, a magnetic sensor, an acceleration sensor, a grip sensor, a color sensor, an infrared (IR) sensor, a biosensor, a temperature sensor, a humidity sensor, or an illuminance sensor.

In a region around the first camera module 105, a proximity sensor (not illustrated) may be disposed under the display 101 to overlap the region of the display 101. In this case, the proximity sensor may be provided in a region adjacent to the camera module 105.

The camera modules 105, 112, and 113 may include the first camera module 105 disposed to face toward the first surface 100A of the electronic device 100, and the second camera module 112, the flash 113, and the TOF sensor 114 that are disposed to face toward the second surface 100B.

The second camera module 112 may include a plurality of cameras (e.g., a dual camera, a triple camera, or a quad camera). However, the second camera module 112 is not necessarily limited to including the plurality of cameras and may include one camera. The TOF sensor 114 may be a depth camera including a TOF type image sensor.

The first camera module 105 and the second camera module 112 may include one or more lenses, an image sensor, and/or an image signal processor.

The flash 113 may include, for example, a light emitting diode or a xenon lamp. In another embodiment, two or more lenses (an IR camera lens, a wide angle lens, and a telephoto lens) and image sensors may be disposed on one surface of the electronic device 100.

In an embodiment, the key input devices 117 may be disposed on the third surface 100C of the electronic device 100. In another embodiment, the electronic device 100 may not include all or some of the key input devices 117, and the key input devices 117 not included may be implemented in a different form, such as a soft key, on the display 101.

In an embodiment, the connector hole 108 may be formed in the third surface 100C of the electronic device 100 such that a connector of an external device is accommodated therein. A connecting terminal electrically connected with the connector of the external device may be disposed in the connector hole 108. The electronic device 100 according to an embodiment may include an interface module for processing electrical signals transmitted and received through the connecting terminal.

In an embodiment, the electronic device 100 may include the light emitting element (not illustrated). For example, the light emitting element (not illustrated) may be disposed on the first surface 100A of the housing. The light emitting element (not illustrated) may provide state information of the electronic device 100 in the form of light. In another embodiment, the light emitting element (not illustrated) may provide a light source that operates in conjunction with operation of the first camera module 105. For example, the light emitting element (not illustrated) may include an LED, an IR LED, and/or a xenon lamp.

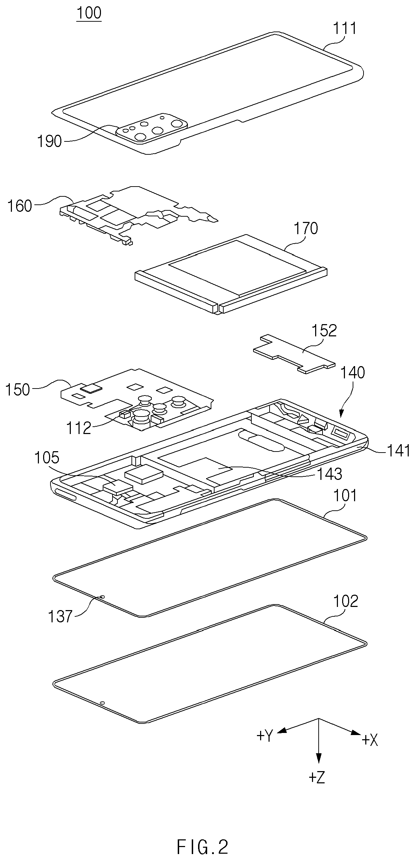

FIG. 2 illustrates an exploded perspective view of the electronic device according to an embodiment.

Hereinafter, repetitive descriptions of components having the same reference numerals as the above-described components will be omitted.

Referring to FIG. 2, the electronic device 100 according to an embodiment may include a frame structure 140, a first printed circuit board 150, a second printed circuit board 152, a cover plate 160, and a battery 170.

In an embodiment, the frame structure 140 may include a sidewall 141 that forms the exterior of the electronic device 100 (e.g., the third surface 100C of FIG. 1) and a support part 143 extending inward from the sidewall 141. In an embodiment, the frame structure 140 may be disposed between the display 101 and the back plate 111. In an embodiment, the sidewall 141 of the frame structure 140 may surround a space between the back plate 111 and the front plate 102 (and/or the display 101), and the support part 143 of the frame structure 140 may extend from the sidewall 141 within the space.

In an embodiment, the frame structure 140 may support or accommodate other components included in the electronic device 100. For example, the display 101 may be disposed on one surface of the frame structure 140 that faces in one direction (e.g., the +Z direction), and the display 101 may be supported by the support part 143 of the frame structure 140. In another example, the first printed circuit board 150, the second printed circuit board 152, the battery 170, and the second camera module 112 may be disposed on an opposite surface of the frame structure 140 that faces in the opposite direction (e.g., the -Z direction) to the one direction. The first printed circuit board 150, the second printed circuit board 152, the battery 170, and the second camera module 112 may be seated in a recess defined by the sidewall 141 and/or the support part 143 of the frame structure 140.

In an embodiment, the first printed circuit board 150, the second printed circuit board 152, and the battery 170 may be coupled with the frame structure 140. For example, the first printed circuit board 150 and the second printed circuit board 152 may be fixedly disposed on the frame structure 140 through a coupling member such as a screw. For example, the battery 170 may be fixedly disposed on the frame structure 140 through an adhesive member (e.g., a double-sided tape). However, the disclosure is not limited by the above-described example.

In an embodiment, the cover plate 160 may be disposed between the first printed circuit board 150 and the back plate 111. In an embodiment, the cover plate 160 may be disposed on the first printed circuit board 150. For example, the cover plate 160 may be disposed on a surface of the first printed circuit board 150 that faces in the -Z direction.

In an embodiment, the cover plate 160 may at least partially overlap the first printed circuit board 150 with respect to the Z axis. In an embodiment, the cover plate 160 may cover at least a partial region of the first printed circuit board 150. Accordingly, the cover plate 160 may protect the first printed circuit board 150 from a physical impact, or may prevent and/or reduce separation of a connector coupled to the first printed circuit board 150.

In an embodiment, the cover plate 160 may be fixedly disposed on the first printed circuit board 150 through a coupling member (e.g., a screw), or may be coupled to the frame structure 140 together with the first printed circuit board 150 through the coupling member.

In an embodiment, the display 101 may be disposed between the frame structure 140 and the front plate 102. For example, the front plate 102 may be disposed on one side of the display 101 (e.g., the +Z direction), and the frame structure 140 may be disposed on an opposite side of the display 101 (e.g., the -Z direction).

In an embodiment, the front plate 102 may be coupled with the display 101. For example, the front plate 102 and the display 101 may be attached to each other through an optical adhesive member (e.g., an optically clear adhesive (OCA) or an optically clear resin (OCR)) interposed therebetween.

In an embodiment, the front plate 102 may be coupled with the frame structure 140. For example, the front plate 102, when viewed in the Z-axis direction, may include an outer portion extending outside the display 101 and may be attached with the frame structure 140 through an adhesive member (e.g., a double-sided tape) disposed between the outer portion of the front plate 102 and the frame structure 140 (e.g., the sidewall 141). However, the disclosure is not limited by the above-described example.

In an embodiment, a processor, a memory, and/or an interface may be mounted on the first printed circuit board 150 and/or the second printed circuit board 152. The processor may include, for example, one or more of a central processing unit, an application processor, a graphic processing unit, an image signal processor, a sensor hub processor, or a communication processor. The memory may include, for example, a volatile memory or a non-volatile memory. The interface may include, for example, a high definition multimedia interface (HDMI), a universal serial bus (USB) interface, an SD card interface, and/or an audio interface. The interface may electrically or physically connect the electronic device 100 with an external electronic device and may include a USB connector, an SD card/MMC connector, or an audio connector. In an embodiment, the first printed circuit board 150 and the second printed circuit board 152 may be operationally or electrically connected with each other through a connecting member (e.g., a flexible printed circuit board).

In an embodiment, the battery 170 may supply power to at least one component of the electronic device 100. For example, the battery 170 may include a secondary cell that is rechargeable or a fuel cell. At least a portion of the battery 170 may be disposed on substantially the same plane as the first printed circuit board 150 and/or the second printed circuit board 152.

The electronic device 100 according to an embodiment may include an antenna module (not illustrated). In an embodiment, the antenna module may be disposed between the back plate 111 and the battery 170. The antenna module may include, for example, a near field communication (NFC) antenna, a wireless charging antenna, and/or a magnetic secure transmission (MST) antenna. For example, the antenna module may perform short-range communication with an external device, or may wirelessly transmit and receive power with the external device.

In an embodiment, the first camera module 105 may be disposed on the support part 143 of the frame structure 140 such that a lens is visually exposed through a partial region of the front plate 102 (e.g., the first surface (or, the front surface) 100A of FIG. 1) of the electronic device 100.

In an embodiment, the first camera module 105 (e.g., a front camera) may be disposed such that the optical axis of the lens at least partially overlaps a hole or recess 137 formed in the display 101, based on the Z axis. For example, the first camera module 105 may be at least partially disposed in an inner space of the hole or recess 137 formed in one surface (e.g., a surface facing in the -Z direction) of the display 101 and may include, for example, a punch hole camera.

In an embodiment, the second camera module 112 (e.g., a rear camera) may be disposed between the frame structure 140 and the back plate 111. In an embodiment, the second camera module 112 may be electrically connected to the first printed circuit board 150 through a connecting member (e.g., a connector). In an embodiment, the second camera module 112 may be disposed such that a lens receives external light through a camera region 190 of the back plate 111 of the electronic device 100.

In an embodiment, the camera region 190 may be formed on a surface of the back plate 111 (e.g., the second surface (or, the rear surface) 100B of FIG. 1). In an embodiment, the camera region 190 may be formed to be at least partially transparent such that external light is incident to the lens of the second camera module 112. In an embodiment, at least a portion of the camera region 190 may protrude to a predetermined height from the surface of the back plate 111. However, the disclosure is not limited thereto, and in another embodiment, the camera region 190 may form substantially the same plane as the surface of the back plate 111.

In an embodiment, the housing of the electronic device 100 may refer to a component or structure that forms at least a portion of the exterior of the electronic device 100. In this respect, at least some of the front plate 102, the frame structure 140, and/or the back plate 111 forming the exterior of the electronic device 100 may be referred to as the housing of the electronic device 100.

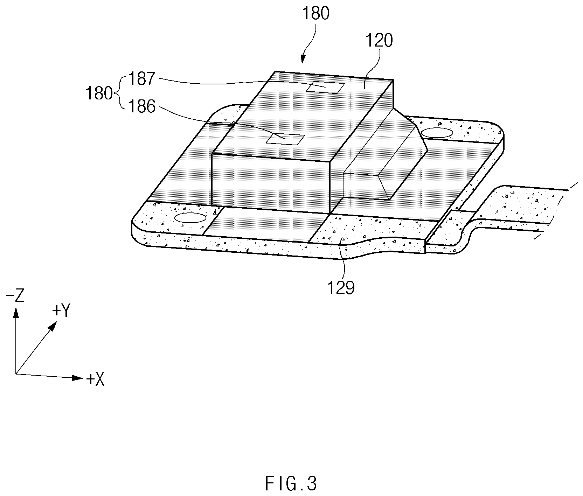

FIG. 3 is a perspective view illustrating a state in which a shielding structure 180 is applied to a sensor module 120 according to an embodiment.

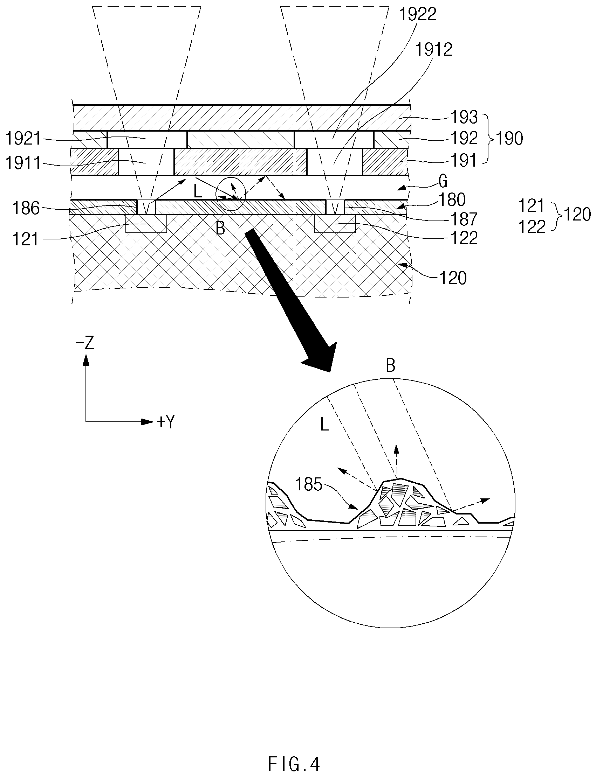

FIG. 4 illustrates a sectional view of an upper structure 190 (e.g., the camera region 190 of FIG. 2), the sensor module 120 (e.g., the TOF sensor 114 of FIG. 2), and the shielding structure 180 taken along line A-A' of FIG. 1 and a blowup of region B.

Referring to FIGS. 3 and 4, the electronic device according to the invention (e.g., the electronic device 100 of FIG. 1 or 2) includes the sensor module 120, the shielding structure 180, and the upper structure 190. The sensor module 120 includes a light emitting unit 121 and a light receiving unit 122. The shielding structure 180 includes a first optical hole 186 and a second optical hole 187.

In an embodiment, the sensor module 120 may be disposed such that one surface (e.g., a surface facing in the -Z direction) faces the back plate of the electronic device 100 (e.g., the back plate 111 of FIG. 2). For example, the sensor module 120 may be a TOF sensor (e.g., the TOF sensor 114 of FIG. 2) that emits light in the rear direction (the -Z direction) through a partial region of the back plate 111 of the electronic device 100 and receives light through a partial region of the back plate 111. In the following embodiments, "upper" means the -Z direction, and "lower" means the +Z direction.

Referring to FIG. 3, in an embodiment, the shielding structure 180 may be formed in the form of a thin film that at least partially surrounds a surface of the sensor module 120. In the invention, the shielding structure 180 includes the first optical hole 186 and the second optical hole 187 that are formed from an upper surface (a surface facing in the -Z direction) to a lower surface (a surface facing in the +Z direction) in contact with one surface (a surface facing in the -Z direction) of the sensor module 120. In an embodiment, the first optical hole 186 and the second optical hole 187 may be spaced apart from each other on the same plane (e.g., the X-Y plane). For example, the first optical hole 186 and the second optical hole 187 may be spaced apart from each other by a predetermined gap along one axis (e.g., the Y axis).

In an embodiment, the first optical hole 186 and/or the second optical hole 187 may include openings formed in the upper surface (the surface facing in the -Z direction) and the lower surface (the surface facing in the +Z direction) of the shielding structure 180 and may include a hollow connecting at least partial regions of the opposite openings. The first optical hole 186 and/or the second optical hole 187 may have various opening shapes (e.g., a circular shape or a quadrilateral shape) and various hollow shapes (e.g., a circular cylinder or a rectangular prism). In an embodiment, the hollow of the first optical hole 186 and/or the second optical hole 187 may be a space that is formed to penetrate along the Z axis and that connects the opposite openings. In this case, light emitted by the sensor module 120 and light incident toward the sensor module 120 physically passes through the first optical hole 186 and/or the second optical hole 187. In an embodiment, the first optical hole 186 and/or the second optical hole 187 may include, in the hollow, an optical member (not illustrated) capable of transmitting light to one region. For example, the optical member may be provided in a form that at least partially blocks the hollow of the shielding structure 180. In this case, light emitted by the sensor module 120 and light incident toward the sensor module 120 may optically pass through the first optical hole 186 and/or the second optical hole 187 that includes the optical member.

The sensor module 120 may be electrically connected to an electronic part 129. In an embodiment, the electronic part 129 may be the first printed circuit board 150 of FIG. 2. In another embodiment, the electronic part 129 may be a connector and/or a printed circuit board that connects the sensor module 120 to the first printed circuit board 150 of FIG. 2.

Referring to FIG. 4, in an embodiment, the upper structure 190 (e.g., the camera region 190 of FIG. 2) may be disposed over the shielding structure 180 (in the -Z direction), which is formed on at least a partial region of the sensor module 120, with an air gap G having a predetermined interval (a distance on the Z axis) therebetween. In FIG. 4, one example of light emitted by the light emitting unit 121 and one example of light received by the light receiving unit 122 are illustrated as dotted line regions. In an embodiment, the upper structure 190 may include a decorative part 191, an intermediate part 192, and a window 193. The decorative part 191 may include a first hole 1911 and a second hole 1912. The intermediate part 192 may include a third hole 1921 and a fourth hole 1922. An arrow L in FIG. 4 shows an example of a path of light induced in the air gap G and diffusely reflected by the shielding structure 180.

In an embodiment, the sensor module 120 may include the light emitting unit 121 and the light receiving unit 122 that are disposed on an upper surface (a surface facing in the -Z direction) so as to be spaced apart from each other. The light emitting unit 121 and the light receiving unit 122 are spaced apart from each other by a predetermined gap along one axis (e.g., the Y axis). The light emitting unit 121 of the sensor module 120 may include a light source (not illustrated) that generates and emits light with a specific wavelength. For example, the light source may generate an infrared beam. Through the upper structure 190, the sensor module 120 may emit light in a direction (e.g., the -Z direction) toward the outside from the electronic device 100 and may receive light in a direction (e.g., the +Z direction) toward the electronic device 100 from the outside. For example, light generated by the light source of the light emitting unit 121 of the sensor module 120 may pass through the first hole 1911, the third hole 1921, and the window 193 via the air gap G and may be at least partially emitted outside the electronic device 100. Light reflected by an object (e.g., a thing and/or a human body) located outside the electronic device 100 may pass through the window 193, the fourth hole 1922, and the second hole 1912 and may be at least partially received by the light receiving unit 122 of the sensor module 120 via the air gap G. For example, the sensor module 120 may measure the time taken by the light to return to the light receiving unit 122, or may measure the distance to the surrounding object by using a phase difference of the light measured by the light emitting unit 121 and the light receiving unit 122.

In an embodiment, the first optical hole 186 and/or the second optical hole 187 of the shielding structure 180 may be at least partially formed through the shielding structure 180 in the Z-axis direction so as to be aligned with the light emitting unit 121 and/or the light receiving unit 122 of the sensor module 120 on the Z axis (or, so as to at least partially overlap the light emitting unit 121 and/or the light receiving unit 122 when viewed in the Z-axis direction (based on the Z axis)).

In an embodiment, the upper structure 190 may be formed by stacking the decorative part 191, the intermediate part 192, and the window 193 in the - Z direction.

According to an embodiment, the decorative part 191 may support the window 193. For example, the decorative part 191 may support the window 193 in a form surrounding at least a portion thereof and may couple the window 193 to the back plate 111. In an embodiment, the upper structure 190 may be referred to as the camera region 190 of FIG. 2. In this case, the decorative part 191 may be, for example, a camera inclosure that surrounds at least a portion of the window 193 (e.g., the periphery of the window 193).

In an embodiment, the first hole 1911 and/or the second hole 1912 of the decorative part 191 may be formed through the decorative part 191 so as to be aligned with the first optical hole 186 and/or the second optical hole 187 of the shielding structure 180 on the Z axis (or, so as to at least partially overlap the first optical hole 186 and/or the second optical hole 187 when viewed in the Z-axis direction).

In an embodiment, the intermediate part 192 may include an adhesive material and may be disposed between the decorative part 191 and the window 193 to couple both the members. The third hole 1921 and/or the fourth hole 1922 of the intermediate part 192 may be formed through the intermediate part 192 so as to be aligned with the first hole 1911 and/or the second hole 1912 of the decorative part 191 on the Z axis (or, so as to at least partially overlap the first hole 1911 and/or the second hole 1912 when viewed in the Z-axis direction). The first optical hole 186, the first hole 1911, and/or the third hole 1921 may at least partially overlap each other with respect to the Z axis. The second optical hole 187, the second hole 1912, and/or the fourth hole 1922 may at least partially overlap each other with respect to the Z axis. For example, the first hole 1911 may have a width, perimeter, and/or area that is substantially the same as or greater than that of the first optical hole 186 and is substantially the same as or smaller than that of the third hole 1921. For example, the second hole 1912 may have a width, perimeter, and/or area that is substantially the same as or greater than that of the second optical hole 187 and is substantially the same as or smaller than that of the fourth hole 1922.

In an embodiment, the window 193 may include, in at least a partial region thereof, a transmissive region (not illustrated) that is formed of a material having higher light transmittance than other regions. The transmissive region of the window 193 may include a region at least partially overlapping the third hole 1921 and/or the fourth hole 1922 of the intermediate part 192 when viewed in the Z-axis direction. For example, the transmissive region of the window 193 may include a transparent material such as glass.

In an embodiment, the air gap G may be defined as a space between a lower surface (a surface facing in the +Z direction) of the decorative part 191 of the upper structure 190 and the upper surface (the surface facing in the -Z direction) of the shielding structure 180. In the air gap G, light may be introduced and moved. An example in which the light indicated by the arrow L is diffusely reflected on a surface of a diffuse reflective layer 185 according to an embodiment is illustrated in the blowup of region B of FIG. 4. The diffuse reflection layer 185 may provide a crosstalk reduction effect through a structure that decreases the reflectance of light.

Specifically, most of light generated by the light source of the light emitting unit 121 may be emitted outside the electronic device 100 through the first hole 1911. However, a portion of the light may be reflected by the upper structure 190 and introduced into the space of the air gap G. The light introduced into the air gap G (hereinafter, referred to as the induced light) may be continuously reflected from the upper surface (the surface facing in the -Z direction) of the shielding structure 180 and the lower surface (the surface facing in the +Z direction) of the decorative part 191. Since the light receiving unit 122 receives light reflected from the object (e.g., a thing and/or a human body) located outside the electronic device 100 as a signal, light incident to the light receiving unit 122 along other paths may form noise for the signal in the light receiving unit 122. For example, the induced light may be reflected from the surface of the shielding structure 180 and/or the surface of the decorative part 191 in the air gap G and received by the light receiving unit 122 and may generate crosstalk that is noise. An increase in crosstalk may cause a decrease in the accuracy of a measurement value for a signal of an optical sensor. In an embodiment, when an optical shielding structure (e.g., the shielding structure 180 of FIG. 3 or 4) including the diffuse reflection layer 185 for lowering the reflectance of light is provided on the surface of the sensor module 120, crosstalk may be decreased, and thus the signal to noise ratio of the optical sensor may be improved.

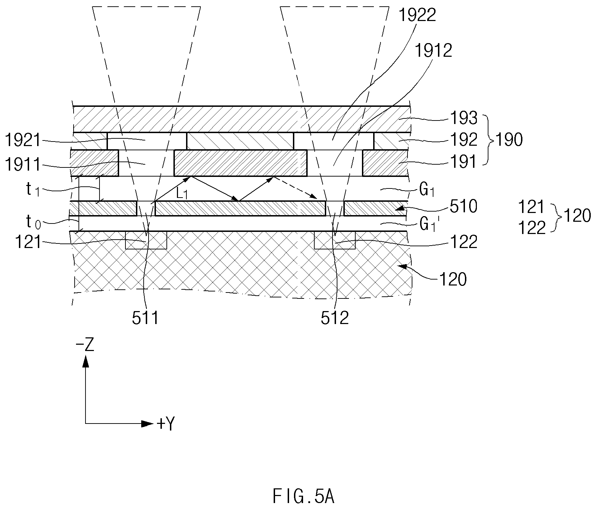

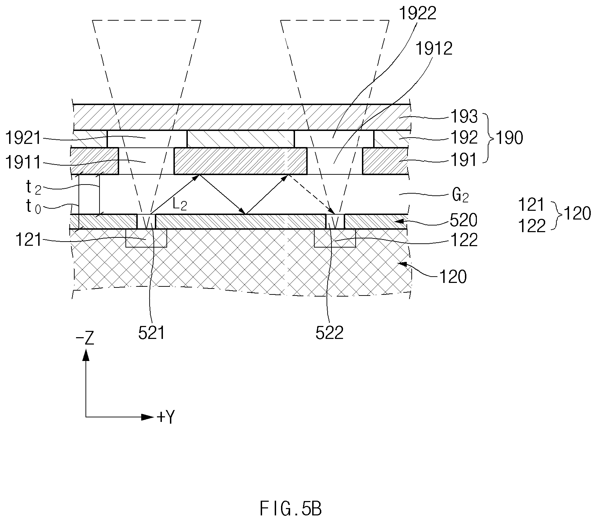

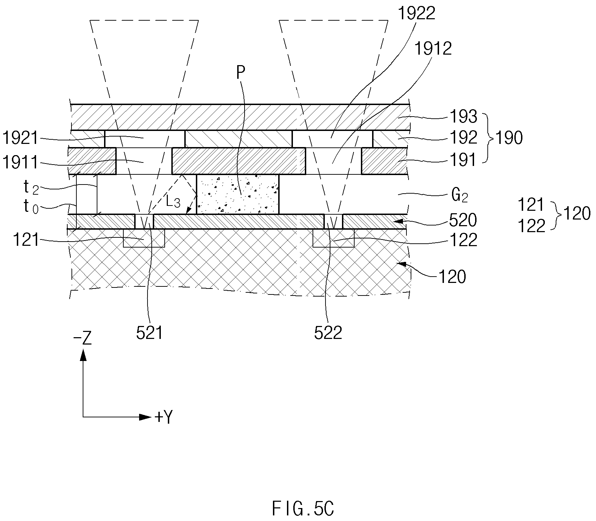

FIG. 5A illustrates a sectional view of a structure in which a shield can 510 is installed over the sensor module 120. FIG. 5B illustrates a sectional view of a structure in which a conformal shield 520 is installed on the sensor module 120. FIG. 5C illustrates a sectional view of a structure in which the conformal shield 520 and a shielding member P are installed on the sensor module 120.

The sensor module 120 of FIGS. 5A, 5B, and 5C (e.g., the sensor module 120 of FIG. 3 or 4), the light emitting unit 121 (e.g., the light emitting unit 121 of FIG. 4) and the light receiving unit 122 (e.g., the light receiving unit 122 of FIG. 4) of the sensor module 120, the upper structure 190 (e.g., the camera region 190 of FIG. 2 or the upper structure 190 of FIG. 4), the decorative part 191 (e.g., the decorative part 191 of FIG. 4), the intermediate part 192 (e.g., the intermediate part 192 of FIG. 4), and the window 193 (e.g., the window 193 of FIG. 4) of the upper structure 190, the first hole 1911 (e.g., the first hole 1911 of FIG. 4) and the second hole 1912 (e.g., the second hole 1912 of FIG. 4) of the decorative part 191, and the third hole 1921 (e.g., the third hole 1921 of FIG. 4) and the fourth hole 1922 (e.g., the fourth hole 1922 of FIG. 4) of the intermediate part 192 have been described above with reference to FIG. 4, and therefore repetitive descriptions will hereinafter be omitted.

Referring to FIG. 5A, an air gap G₁ having an interval of t₁ may be formed between the shield can 510 and the upper structure 190. The shield can 510 may be installed over the sensor module 120 (in the -Z direction) with a separation space G₁' having a predetermined interval therebetween. The shield can 510 may include a first through-hole 511 and a second through-hole 512 through which at least some light generated by the light source (not illustrated) of the light emitting unit 121 and at least some light received by the light receiving unit 122 physically and/or optically pass. A portion of light emitted by the light emitting unit 121 of the sensor module 120 may be introduced into the air gap G₁ and may travel toward the light receiving unit 122 along a path indicated by an arrow L₁ of FIG. 5A.

Referring to FIG. 5B, an air gap G₂ having an interval of t₂ may be formed between the conformal shield 520 and the upper structure 190. The conformal shield 520 may include a third through-hole 521 and a fourth through-hole 522 through which at least some light generated by the light source (not illustrated) of the light emitting unit 121 and at least some light received by the light receiving unit 122 physically and/or optically pass. A portion of light emitted by the light source of the light emitting unit 121 of the sensor module 120 may be introduced into the air gap G₂ and may travel toward the light receiving unit 122 along a path indicated by an arrow L₂ of FIG. 5B.

Hereinafter, the shield can 510 and the conformal shield 520 described with reference to FIGS. 5A and 5B are compared. In FIGS. 5A and 5B, the interval t₀ between the sensor module 120 and the upper structure 190 may be substantially the same. Since the shield can 510 forms the separation space G₁' between the shield can 510 and the sensor module 120 in FIG. 5A, the interval t₁ of the air gap G₁ may be formed to be smaller than the interval t₂ of the air gap G₂ when the conformal shield 520 is applied in FIG. 5B. As the intervals of the air gaps G₁ and G₂ are decreased, the number of reflections relative to a movement distance of light may be increased. Since the energy of the light is decreased every time the light is reflected, the value of crosstalk in which the light is received by the light receiving unit 122 to generate noise other than a signal may be decreased when the number of reflections relative to the movement distance of the light is increased.

FIG. 5C illustrates a structure in which the shielding member P is installed on the conformal shield 520 illustrated in FIG. 5B. The intervals t₀ and t₂ of FIG. 5B may be substantially the same as the intervals t₀ and t₂ of FIG. 5C. The shielding member P may be a means capable of optically and/or physically shielding the space between the light emitting unit 121 and the light receiving unit 122. For example, the shielding member P may be a sponge. For example, the shielding member P may be installed in at least a partial region of the air gap G₂ located between the light emitting unit 121 and the light receiving unit 122. The shielding member P may reduce crosstalk by absorbing and/or reflecting at least a portion of light introduced into the light receiving unit 122 from the light emitting unit 121. For example, a portion of light emitted by the light source (not illustrated) of the light emitting unit 121 of the sensor module 120 may be reflected by the shielding member P along a path indicated by an arrow L₃ of FIG. 5C.

Hereinafter, results of comparative experiments for confirming a crosstalk reduction effect by the shielding structure 180 of the disclosure will be described with reference to FIGS. 5A, 5B, and 5C.

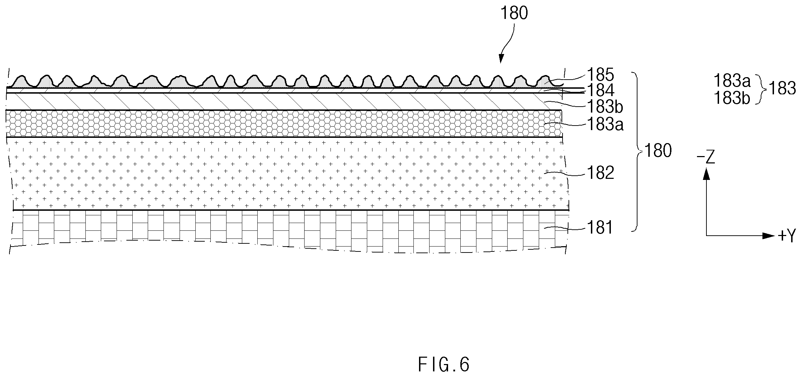

Crosstalk measurement values of the comparative experiments are listed in [Table 1]. Referring to [Table 1], experimental examples A, B-1, B-2, and B-3 are comparative examples, and an experimental example C is an experimental example to which one embodiment of the disclosure is applied. The experimental example A is an example in which a shield can (e.g., the shield can 510 of FIG. 5A) is applied, and the experimental example B-1 is an example in which a conformal shield (e.g., the conformal shield 520 of FIG. 5B) is applied. The experimental example B-2 is an example in which a conformal shield is applied and an interval adjustment member (not illustrated) for reducing the interval of an air gap (the air gap G₂ of FIG. 5B) is added. The experimental example B-3 is an example in which a conformal shield is applied and an interval adjustment member and a shielding member (e.g., the shielding member P of FIG. 5C) are added. The conformal shields applied to the respective experimental examples B-1, B-2, and B-3 are substantially the same as one another. For example, the conformal shields may include a conductive adhesive layer 181 and a shielding film layer 182 that will be described below with reference to FIG. 6.

**[Table 1]**

| Shielding Type | Shield Can | Conformal Shield | | | |
|---|---|---|---|---|---|
| | Experimental Example A | Experimental Example B-1 | Experimental Example B-2 | Experimental Example B-3 | Experimental Example C |
| Window (mm) | 0.33 | 0.33 | 0.33 | 0.33 | 0.33 |
| Intermediate part (mm) | 0.2 | 0.2 | 0.2 | 0.2 | 0.2 |
| Decorative part (mm) | 0.38 | 0.38 | 0.38 | 0.38 | 0.38 |
| Air Gap (mm) | 0.1 | 0.32 | 0.22 | 0.22 | 0.2 |
| Shield Can (mm) | 0.15 | 0 | 0 | 0 | 0 |
| Reflectance Reduction Layer (mm) | 0 | 0 | 0 | 0 | 0.02 |
| Conformal Shield (mm) | 0 | 0.03 | 0.03 | 0.03 | 0.03 |
| Separation Space (mm) | 0.1 | 0 | 0 | 0 | 0 |
| Interval Adjustment Member (mm) | 0 | 0 | 0.1 | 0.1 | 0.1 |
| te(mm) | 0.35 | 0.35 | 0.25 | 0.25 | 0.23 |
| Crosstalk | 50 | 391 | 177 | 49 | 50 |

Referring to [Table 1], the measurement values (mm) other than the crosstalk values may be the intervals of the air gaps or the separation spaces or the thicknesses of other members with respect to the Z axis when the measurement targets are viewed from a side as illustrated in FIG. 5A, 5B, or 5C. The values listed in [Table 1] may all be approximate values. Referring to [Table 1], substantially the same sensor modules (e.g., the sensor module 120 of FIG. 4, 5A, 5B, or 5C) and substantially the same upper structures (e.g., the upper structure 190 of FIG. 4, 5A, 5B, or 5C) may be applied to the respective experimental examples. In the respective examples, the windows (e.g., the window 193 of FIG. 4, 5A, 5B, or 5C) may have substantially the same thickness (mm), the intermediate parts (e.g., the intermediate part 192 of FIG. 4, 5A, 5B, or 5C) may have substantially the same thickness (mm), and the decorative parts (e.g., the decorative part 191 of FIG. 4, 5A, 5B, or 5C) may have substantially the same thickness (mm).

In [Table 1], the intervals tₑ (mm) may be the intervals between the sensor modules and the upper structures and may correspond to, for example, the interval between the surface of the sensor module that faces in the -Z direction and the surface of the decorative part that faces in the +Z direction in FIG. 5A, 5B, or 5C. The tₑ values (e.g., about 0.35 mm) in the experimental examples A and B-1 may be substantially the same as each other. For example, tₑ (e.g., about 0.35 mm) in the experimental example A may be referred to as t₀ in FIG. 5A and may be the sum of the interval (e.g., about 0.1 mm) of the air gap, the thickness (e.g., about 0.15 mm) of the shield can, and the interval (e.g., about 0.1 mm) of the separation space. For example, tₑ (e.g., about 0.35 mm) in the experimental example B-1 may be referred to as t₀ in FIG. 5B or 5C and may be the sum of the interval (e.g., about 0.32 mm) of the air gap and the thickness (e.g., about 0.03 mm) of the conformal shield. In the case in which the interval adjustment member is installed on a lower surface of a printed circuit board on which the sensor module is disposed as in the experimental example B-2, B-3, or C, the sensor module may be moved in the -Z direction, and thus tₑ (e.g., about 0.25 mm) may be decreased by the thickness (e.g., about 0.1 mm) of the interval adjustment member.

Hereinafter, the experimental examples will be described, and the crosstalk values between the experimental examples will be compared.

The experimental examples A and B-1 are examples for experimenting on changes in crosstalk values depending on shielding types that form air gaps having different intervals. The thickness (e.g., about 0.15 mm) of the shield can in the experimental example A may be greater than the thickness (e.g., about 0.03 mm) of the conformal shield in the experimental example B-1. The shield can in the experimental example A may be formed with the separation space (e.g., the separation space G₁' of FIG. 5A) having a predetermined interval (e.g., about 0.1 mm) between the shield can and a surface of the facing sensor module. Accordingly, tₑ (e.g., about 0.35 mm) in the experimental example A and tₑ (e.g., about 0.35 mm) in the experimental example B-1 may be substantially the same as each other, but the interval (e.g., about 0.1 mm) of the air gap in the experimental example A (e.g., the air gap G₁ of FIG. 5A) may be smaller than the interval (e.g., about 0.32 mm) of the air gap in the experimental example B-1 (e.g., the air gap G₂ of FIG. 5B). In the experimental example A, due to the interval of the air gap smaller than that in the experimental example B-1, the crosstalk value (e.g., about 50) may be measured to be lower than the crosstalk value (e.g., about 391) in the experimental example B-1.

The experimental example B-2 is an example for experimenting on a change in a crosstalk value depending on a change in the interval of the air gap and may be an example in which the remaining conditions are the same as those in the experimental example B-1, but the interval adjustment member (not illustrated) is additionally installed. For example, the interval adjustment member may be a temporarily and experimentally installed member and may be a tape attached to a surface (hereinafter, referred to as a lower surface) opposite to a surface where the sensor module is installed on a member (e.g., the electronic part 129 of FIG. 3) on which the sensor module is mounted. For example, in the experimental example B-2, the conformal shield and the interval adjustment member (e.g., a tape) having a thickness of about 0.1 mm may be applied to the sensor module. Accordingly, the interval (e.g., about 0.22 mm) of the air gap (not illustrated) in the experimental example B-2 may be smaller than the interval (e.g., about 0.32 mm) of the air gap in the experimental example B-1 (e.g., the air gap G₂ of FIG. 5B) by the thickness of the interval adjustment member. Thus, in the experimental example B-1, due to the interval of the air gap smaller than that in the experimental example B-2, the crosstalk value (e.g., about 177) may be lower than the crosstalk value (e.g., about 391) in the experimental example B-1.

The experimental example B-3 is an example for experimenting on a change in a crosstalk value depending on the installation of the shielding member (e.g., the shielding member P of FIG. 5C) between a light emitting unit (e.g., the light emitting unit 121 of FIG. 4, 5A, 5B, or 5C) and a light receiving unit (e.g., the light receiving unit 122 of FIG. 4, 5A, 5B, or 5C) of the sensor module. The remaining conditions in the experimental example B-3 except the shielding member may all be substantially the same as those in the experimental example B-2. For example, in the experimental example B-3, the conformal shield and the interval adjustment member may be installed as in the experimental example B-2, and the shielding member blocking the space between the light emitting unit and the light receiving unit may be additionally installed. For example, the shielding member may be a member (e.g., a sponge) that physically and/or optically blocks travel of light in the air gap between the light emitting unit and the light receiving unit. The crosstalk value (e.g., about 49) in the experimental example B-3 may be lower than the crosstalk value (e.g., about 177) in the experimental example B-2 in which only the interval adjustment member is installed and may substantially similarly approximate to the crosstalk value (e.g., about 49) in the experimental example A in which the shield can is applied.

The experimental example C is an example for experimenting on a change in a crosstalk value depending on the formation of the reflectance reduction layer (not illustrated) on a surface of the conformal shield (e.g., the conformal shield 520 of FIG. 5C). The remaining conditions in the experimental example C except the reflectance reduction layer may all be substantially the same as those in the experimental example B-2. For example, in the experimental example C, the conformal shield and the interval adjustment member may be installed as in the experimental example B-2, and the reflectance reduction layer may be additionally formed on the surface of the conformal shield. For example, the conformal shield and the reflectance reduction layer may be referred to as the shielding structure 180 of FIG. 3 or 4. For example, the reflectance reduction layer may include a base film layer, a lusterless layer, and a diffuse reflection layer (e.g., the diffuse reflection layer 185 of FIG. 4) that will be described below with reference to FIG. 6. The reflectance reduction layer may induce diffuse reflection and/or scattering of light on the surface. Accordingly, the crosstalk value (e.g., about 50) in the experimental example C may be lower than the crosstalk value (e.g., about 177) in the experimental example B-2 and may be substantially the same as the crosstalk value (e.g., about 50) in the experimental example A in which the shield can is applied. In the experimental example C, the decrease in the interval (e.g., about 0.2 mm) of the air gap (not illustrated) by the thickness (e.g., about 0.02 mm) of the reflectance reduction layer, compared to the interval (e.g., about 0.22 mm) of the air gap (not illustrated) in the experimental example B-2, may also contribute to the decrease in the crosstalk value. The crosstalk value (e.g., about 50) in the experimental example C may substantially similarly approximate to the crosstalk value (e.g., about 49) in the experimental example B-3 in which the interval adjustment member (e.g., a tape) and the shielding member (e.g., a sponge) are added to the conformal shield.

In the disclosure, the sensor module 120 is mounted to emit light in the rear direction of the electronic device 100 (e.g., a direction toward the second surface (or, the rear surface) 100B of FIG. 1). However, embodiments of the disclosure are not limited thereto. For example, the sensor module 120 may be an optical sensor including a proximity sensor or a TOF sensor that is disposed to face the front plate of the electronic device 100 (e.g., the front plate 102 of FIG. 1 or 2) and that emits light in the front direction (e.g., a direction toward the first surface (or, the front surface) 100A of FIG. 1). In this case, the upper structure 190 described above with reference to FIG. 4 may correspond to the front plate 102 of the electronic device 100 of FIG. 2 or at least a portion of the display 101 and the front plate 102 of FIG. 2. For example, in a case in which the sensor module 120 is provided under the display 101 or accommodated in an inner space of a recess formed on the display 101, the upper structure 190 may correspond to at least a portion of the display 101 and the front plate 102. For example, in a case in which the sensor module 120 is accommodated in an inner space of a hole formed through the display 101, the upper structure 190 may correspond to at least a portion of the front plate 102. Furthermore, unlike in the embodiments described above with reference to FIGS. 3 and 4, "upper" means the +Z direction, and "lower" means the -Z direction. The above-described shielding structure 180 may be identically applied to a proximity sensor.

In the disclosure, the electronic device 100 (e.g., the electronic device 100 of FIG. 1 or 2) is illustrated in the shape of a wireless communication terminal. However, embodiments of the disclosure are not limited thereto. The shielding structure of embodiments of the disclosure may be applied to sensor modules of various electronic devices, such as tablet PCs, in addition to the sensor module of the wireless communication terminal.

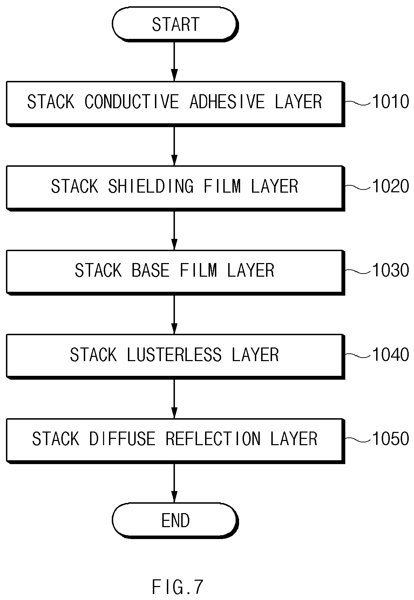

FIG. 6 illustrates a sectional view of the shielding structure 180 according to an embodiment. FIG. 7 illustrates a view illustrating an operation of forming the shielding structure according to an embodiment.

Referring to FIG. 6, in an embodiment, the shielding structure 180 (e.g., the shielding structure 180 of FIG. 3 or 4) may include the conductive adhesive layer 181, the shielding film layer 182, the base film layer 183, the lusterless layer 184, and the diffuse reflection layer 185 sequentially stacked in the -Z direction.

Referring to FIG. 7, in operation 1010, the conductive adhesive layer 181 may be stacked. In an embodiment, the conductive adhesive layer 181 may be formed on at least a portion of the upper surface (the surface facing in the -Z direction) of the sensor module 120 (e.g., the sensor module 120 of FIG. 3 or 4). The conductive adhesive layer 181 may attach the shielding structure 180 to the surface of the sensor module 120. The conductive adhesive layer 181 may be formed by adding conductive particles, such as graphite and nickel, to an adhesive, but is not limited thereto. The adhesive may be, for example, a pressure sensitive adhesive (PSA). Due to the conductivity, the conductive adhesive layer 181 may form an electrical path between a ground region of a circuit board (e.g., the electronic part 129 of FIG. 3) to which the sensor module 120 located below is electrically connected and the conductive shielding film layer 182 located above. By forming the electrical path, the conductive adhesive layer 181 may shield electromagnetic noise that is likely to be received by the sensor module 120. For example, the conductive adhesive layer 181 may have a thickness of about 10 µm.

Referring to FIG. 7, in operation 1020, the shielding film layer 182 may be stacked. In an embodiment, the shielding film layer 182 may be formed on at least a portion of an upper surface (a surface facing in the -Z direction) of the conductive adhesive layer 181 to form a conformal shield having a thin film form on the surface of the sensor module 120 together with the conductive adhesive layer 181. For example, the shielding film layer 182 may include nano fibers and a conductive material such as metal. When the shielding film layer 182 is formed of nano fibers, noise may be relatively reduced, as compared with when the shielding film layer 182 is formed of a metal coating. For example, when the shielding film layer 182 is formed of a metal coating without nano fibers, relatively greater crosstalk may occur due to light reflected from a surface of the shielding film layer 182 exposed through the first and second optical holes 186 and 187 (e.g., the first and second optical holes 186 and 187 of FIG. 3 or 4) than when the shielding film layer 182 includes nano fibers. When the shielding film layer 182 is formed of nano fibers, exposed surfaces of the first and second optical holes may also have lusterless characteristics, and thus the reflectance on the exposed surfaces may be reduced.

For example, a nano fiber fabric may have a thickness of about 1 µm to about 10 µm. For example, the shielding film layer 182 may be formed by coating the nano fiber fabric with one or more metals (e.g., nickel (Ni) or copper (Cu)). For example, the shielding film layer 182 may be formed by plating the nano fiber fabric in the order of nickel-copper-nickel. For example, the shielding film layer 182 may have a thickness of about 20 µm.

In another embodiment, the shielding film layer 182 may be formed by coating the surface of the sensor module 120 with metal such as copper or aluminum. In this case, a coating may be formed on a surface of the metal coating using a material having a lusterless property, such as black ink.

Referring to FIG. 7, in operation 1030, the base film layer 183 may be stacked. In an embodiment, the base film layer 183 may be formed on at least a portion of an upper surface (a surface facing in the -Z direction) of the shielding film layer 182. The base film layer 183 may include an adhesive layer 183a formed on the shielding film layer 182 and a film layer 183b formed on the adhesive layer 183a. The adhesive layer 183a may be, for example, a pressure sensitive adhesive (PSA). The film layer 183b may be made of a synthetic resin and may be formed of, for example, a polyethyleneterephthalate (PET) film. For example, the adhesive layer 183a may have a thickness of about 6 µm, and the film layer 183b may have a thickness of about 3.5 µm.

Referring to FIG. 7, in operation 1040, the lusterless layer 184 may be stacked. In an embodiment, the lusterless layer 184 may be formed on at least a portion of an upper surface (a surface facing in the -Z direction) of the base film layer 183. In an embodiment, the lusterless layer 184 may be made of carbon black. In a case of directly coating (e.g., gravure coating) the surface of the shielding film layer 182 made of nano fibers with the lusterless layer 184, it may be difficult to substantially uniformly form the thickness of the lusterless layer 184. This is because when the shielding film layer 182 includes nano fibers, it is difficult to form a thin film having a uniform thickness on the corresponding surface due to high surface roughness. In contrast, when the base film layer 183 is formed on the shielding film layer 182 according to an embodiment, the base film layer 183 may be coated (e.g., gravure coated) with the lusterless layer 184 having a substantially uniform thickness. The lusterless layer 184 may be configured to include a material capable of reducing the reflectance of light on a surface. For example, the lusterless layer 184 may be formed by coating the base film layer 183 with black ink.

In another embodiment, the lusterless layer 184 may be formed by performing comma coating. However, when the comma coating is performed, the electromagnetic noise shielding performance of the shielding film layer 182 may be lowered, as compared with when gravure coating is performed. Since the amount of applied coating material in the comma coating is larger than that in the gravure coating, the coating material of the lusterless layer 184 may infiltrate into the nano fiber fabric when the coating material of the lusterless layer 184 is directly applied to the shielding film layer 182 by the comma coating. The coating material of the lusterless layer 184 that infiltrates into the nano fiber fabric may block electrical connection between the upper diffuse reflection layer 185 and the lower conductive adhesive layer 181 by the conductive particles of the shielding film layer 182. Accordingly, the electromagnetic noise shielding performance of the shielding film layer 182 may be lowered. This phenomenon may be prevented by sequentially applying the shielding film layer 182, the base film layer 183, and the lusterless layer 184 according to an embodiment.

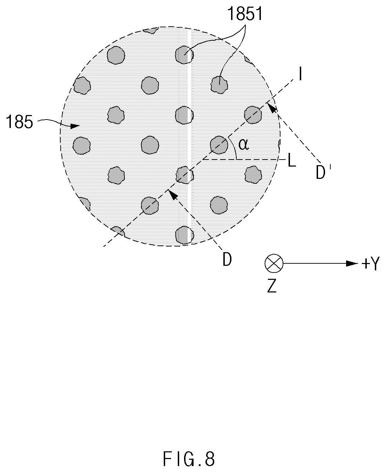

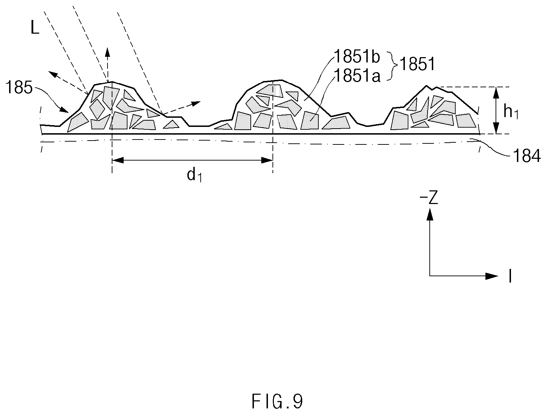

Referring to FIG. 7, in operation 1050, the diffuse reflection layer 185 may be stacked. In an embodiment, the diffuse reflection layer 185 may be formed on at least a portion of an upper surface (a surface facing in the -Z direction) of the lusterless layer 184. For example, the diffuse reflection layer 185 may be formed on at least a partial region including the region of the upper surface (the surface facing in the -Z direction) of the lusterless layer 184 located between the light emitting unit 121 and the light receiving unit 122 of the sensor module 120 (e.g., the sensor module 120 of FIG. 3 or 4). The diffuse reflection layer 185 may be formed by coating (e.g., gravure coating) a silica mixture coating material. In an embodiment, operation 1050 may include an operation of forming a plurality of raised parts (e.g., raised parts 1851 to be described below with reference to FIG. 8 or 9) on at least a portion of a surface of the diffuse reflection layer 185. The diffuse reflection layer 185 may have a shape in which fine raised parts are patterned on the surface and may thus diffusely reflect or scatter light incident on the surface.

FIG. 8 illustrates a plan view of the diffuse reflection layer 185 according to an embodiment. FIG. 9 illustrates a sectional view of the diffuse reflection layer 185 taken along line D-D' of FIG. 8.

FIG. 8 illustrates a plan view of the diffuse reflection layer 185 (e.g., the diffuse reflection layer 185 of FIG. 4 or 6) according to an embodiment as viewed from above in the Z-axis direction. Referring to FIG. 8, the diffuse reflection layer 185 according to an embodiment may include the raised parts 1851 on at least a partial region of an upper surface (e.g., a surface of the diffuse reflection layer 185 of FIG. 4 or 6 that faces in the -Z direction).

According to an embodiment, the plurality of raised parts 1851 may be formed to be spaced apart from each other along an axis I illustrated in FIG. 8. The axis I may form an angle of α with an axis L. For example, the axis L may correspond to a direction in which the light emitting unit 121 (e.g., the light emitting unit 121 of FIG. 4) and the light receiving unit 122 (e.g., the light receiving unit 122 of FIG. 4) are spaced apart from each other. For example, the axis L may correspond to a direction in which the first optical hole 186 (e.g., the first optical hole 186 of FIG. 3 or 4) and the second optical hole 187 (e.g., the second optical hole 187 of FIG. 3 or 4) are spaced apart from each other. For example, the axis L may be substantially parallel to the Y axis. For example, the angle α may be about 45°, but is not limited thereto. In an embodiment, the plurality of raised parts 1851 may be formed to form a plurality of columns. For example, the plurality of raised parts 1851 may be spaced apart from each other along the axis I and/or a direction substantially perpendicular to the axis I. For example, as illustrated in FIG. 8, the raised parts 1851 may be disposed to form a grid pattern, but is not limited thereto.

Referring to FIG. 9, in the invention, the diffuse reflection layer 185 is formed of a silica mixture that includes silica particles 1851a and a binder 1851b connecting the plurality of silica particles 1851a. In the invention, the raised parts 1851 has a mountain shape including a plurality of inclined surfaces that are inclined with respect to the Z-axis. For example, the pitch d₁ between the raised parts 1851 may range from about 100 µm to about 200 µm.

In an embodiment, the silica particles 1851a contained in the silica mixture of the raised parts 1851 may have an irregular shape. The shape of the raised parts 1851 may be changed depending on factors such as the shape of the silica particles 1851a, the viscosity of the silica mixture, the transfer rate of coating (e.g., gravure coating), and/or curing time. For example, when the silica mixture has a low viscosity, the degree of smoothing immediately after transfer may be increased, and thus the height h₁ of the raised parts 1851 may be formed to be low. The height h₁ of the raised parts 1851 may be set to about 1 µm to about 3 µm.

In an embodiment, the binder 1851b of the raised parts 1851 may be formed of a material having higher transparency (higher light transmittance) than the translucent silica particles 1851a. The silica mixture may have characteristics of grind glass. For example, when light enters the silica mixture, one portion of the light may be diffusely reflected by the uneven surface as shown by an arrow L in FIG. 9, and another portion of the light may pass through the binder 1851b having higher light transmittance than the silica particles 1851a and may be scattered by the silica particles 1851a contained in the binder 1851b. The diffuse reflection layer 185 may induce diffuse reflection and scattering on the surface thereof and may lower the reflectance of light in the shielding structure 180 to about 2% or less. Referring to FIG. 8, the silica particles 1851a according to an embodiment may have an irregular plate shape, but are not limited thereto. To form the diffuse reflection layer 185 in the form of a thin film, the lengths of the silica particles 1851a may be maintained within a predetermined numerical range. For example, the lengths of the silica particles 1851a may be maintained in the range of about 1 µm to about 4 µm.

Hereinafter, a roller 200 for coating (e.g., gravure coating) the lusterless layer 184 (e.g., the lusterless layer 184 of FIG. 6) and/or the diffuse reflection layer 185 (e.g., the diffuse reflection layer 185 of FIG. 4, 6, 8, or 9) and a coating process using the roller 200 will be described.

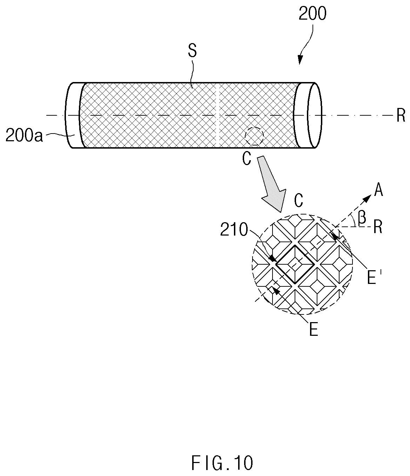

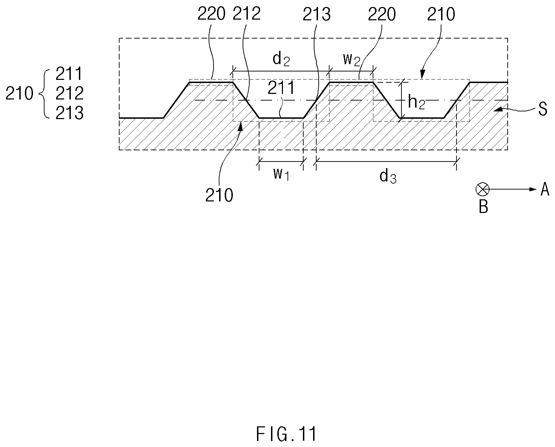

FIG. 10 illustrates a perspective view of the roller 200 and a blowup of region C according to an embodiment. FIG. 11 illustrates a sectional view of a printing surface S of the roller 200 taken along line E-E' of FIG. 10.

Referring to FIGS. 10 and 11, the roller 200 for coating (e.g., gravure coating) used in an operation of stacking the lusterless layer 184 (e.g., operation 1040 of FIG. 7) and/or an operation of stacking the diffuse reflection layer 185 (e.g., operation 1050 of FIG. 7) may include a roller body 200a and cells 210 on the printing surface S that is a surface of the roller body 200a. In an embodiment, each of the cells 210 formed on the printing surface S of the roller 200 may include a bottom portion 211, a first sidewall 212, a second sidewall 213, and a connecting portion 220. The height h₂ of the cell 210, the width w₁ of the bottom portion 211, the width w₂ of the connecting portion 220, the distance d₂ between the connecting portions 220, and the pitch d₃ between the cells 210 illustrated in FIG. 11 may be lengths measured based on a first direction A.

In an embodiment, the roller body 200a may have a cylindrical shape, but is not limited thereto. For example, the roller 200 (e.g., the roller body 200a) may be rotated about a rotational axis R substantially parallel to the lengthwise direction thereof. In an embodiment, the roller 200 may include the plurality of fine cells 210 formed in a concave shape on the printing surface S. Referring to the blowup of region C of the roller 200 of FIG. 10, the plurality of cells 210 may be formed to be spaced apart from each other in the first direction A that forms a predetermined angle β with the rotational axis R. For example, the angle β may be about 45°, but is not limited thereto. For example, the cells 210 adjacent to each other may be formed to be spaced apart from each other at a predetermined interval in the first direction A and/or a direction substantially perpendicular to the first direction A. For example, the cells 210 may be arranged in a grid pattern as illustrated in the blowup of region C of FIG. 10.

A coating (e.g., gravure coating) process used in the manufacture of the lusterless layer 184 and/or the diffuse reflection layer 185 may be performed, for example, by a method in which when a coating material is applied to the printing surface S of the roller, the coating material is maintained in the concave portions of the cells 210 and the roller 200 rotates to transfer the coating material to an object to be printed. At this time, by pressing a base material toward the surface of the roller using a pressing roller, the transfer rate may be relatively raised, as compared with when the pressing roller is not used. The coating material may be transferred to the object in a convex shape corresponding to the concave shape of the cells 210. For example, the cells 210 may have a saw-toothed wheel form for forming the raised parts 1851 (e.g., the raised parts 1851 of FIG. 8 or 9) of the diffuse reflection layer 185 (e.g., the diffuse reflection layer 185 of FIG. 4, 6, 8, or 9) in the shielding structure 180 (e.g., the shielding structure 180 of FIG. 3, 4, or 6), but is not limited to the aforementioned example.

In an embodiment, the coating material may be subjected to a curing process after the transfer process. In the curing process, the surface shape of the coating transferred to the object may be changed. For example, after transferred onto the object to be printed (e.g., the lusterless layer 184 of FIG. 6), a silica mixture coating material may have, on an upper portion having a mountain shape, a flat region (not illustrated) corresponding to the bottom surface of the roller 200. In the curing process, the flat region may be smoothed out and may be narrowed or eliminated. The degree of smoothing in the curing process may be controlled by the viscosity of the silica mixture coating material. The silica mixture coating material, after transferred, may have a second region (not illustrated) that corresponds to the connecting portion 220 of the roller. For example, when the connecting portion 220 has the shape of a flat surface, the second region may also have the shape of a flat surface. When the silica mixture is smoothed in the curing process, the second region may be narrowed or eliminated, and thus the adjacent raised parts 1851 may be in contact with each other.

Referring to FIG. 11, in an embodiment, the bottom portion 211 may have the width w₁ that is length measured in the first direction A. The first sidewall 212 and the second sidewall 213 may form inclined surfaces that are inclined at a predetermined angle with respect to the first direction A. The bottom portion 211 and the first and second sidewalls 212 and 213 may form at least a portion of a concave shape, and the coating material (e.g., a silica mixture) may be injected and maintained.

According to an embodiment, the connecting portion 220 having the width w₂, which is a length measured in the first direction A, may be formed between the first sidewall 212 and the second sidewall 213 of the cells 210 adjacent to each other. Two connecting portions 220 adjacent to each other may be spaced apart from each other by the distance d₂. For example, the distance d₂ may be greater than or equal to the width w₁ of the bottom portion 211. In this case, when the coating material is injected into the cell 210, the coating material may easily infiltrate into the corner regions where the bottom portion 211 is connected with the sidewalls (e.g., the first sidewall 212 or the second sidewall 213), as compared with the case in which the distance d₂ is smaller than the width w₁ of the bottom portion 211. Furthermore, when the distance d₂ is greater than or equal to the width w₁, the path along which the injected coating material is discharged may be gradually expanded, and thus the rate at which the coating material injected into the cell 210 is transferred onto the object to be printed may be increased.

In an embodiment, the pitch d₃ between the adjacent cells 210 may be substantially the same as the pitch d₁ between the raised parts 1851 (e.g., the raised parts 1851 of FIG. 8 or 9) that are adjacent to each other in the diffuse reflection layer 185. The height h₂ of the cells 210 may be set to a numerical value corresponding to the height h₁ of the raised parts 1851 desired to be formed with the roller 200. For example, when the height h₁ of the raised parts 1851 ranges from about 1 µm to about 3 µm, the height h₂ of the cells 210 may range from about 1 µm to about 3 µm. In various embodiments, the depth (e.g., the height h₂ of FIG. 11) and shape of the cells 210 may be diversely set depending on factors such as the surface shape of a coating layer, a transfer pattern, the viscosity of the coating material, and/or the amount of applied coating material.

In an embodiment, when the number of cells 210 per 1 square inch area of the printing surface S of the roller 200 (hereinafter, referred to as the number of necks) is increased, the size of the cells 210 may be decreased, and therefore transfer may not be easily performed. Accordingly, the viscosity of the coating material has to be lowered. In contrast, when the number of necks is decreased, transfer may be relatively easily performed, and thus the viscosity of the coating material may be raised. When coating is performed to form a protruding shape on a surface, the viscosity of the coating material may be set to be higher than when a protruding shape does not exist.

In an embodiment, the diffuse reflection layer 185 may be coated (e.g., gravure coated) such that the patterned fine raised parts 1851 are formed on the surface, and the lusterless layer 184 may be coated (e.g., gravure coated) to have a layer having a substantially uniform thickness without a protruding shape such as the raised parts 1851. In this case, for example, in the coating (e.g., gravure coating) process of forming the diffuse reflection layer 185, the viscosity of a coating material may be set to be higher than that in the coating process of forming the lusterless layer 184, and the number of necks of the roller 200 may be set to be smaller than that in the coating process of forming the lusterless layer 184. For example, the number of necks of a roller used for coating the diffuse reflection layer 185 may be about 200, and the viscosity of a coating material (e.g., a silica mixture) may be about 150 mm²/s. For example, the number of necks of a roller used for coating the lusterless layer 184 may be about 250, and the viscosity of a coating material (e.g., carbon black) may be about 50 mm²/s.

In various embodiments, the shape of the raised parts 1851 may be changed depending on a reflectance value required for the diffuse reflection layer 185. The shape (height, width, pitch, surface roughness, and/or slope) of the raised parts 1851 may be adjusted, for example, through factors such as the viscosity of a coating material, the shape of the cells 210 of the roller 200, the number of necks of the roller 200, the speed ratio and the RPM of the roller 200, and/or curing time after transfer. For example, when the diffuse reflection layer 185 is coated using the roller 200 in which the number of necks is about 200, the pitch d₃ of the raised parts 1851 may range from about 100 µm to about 200 µm.

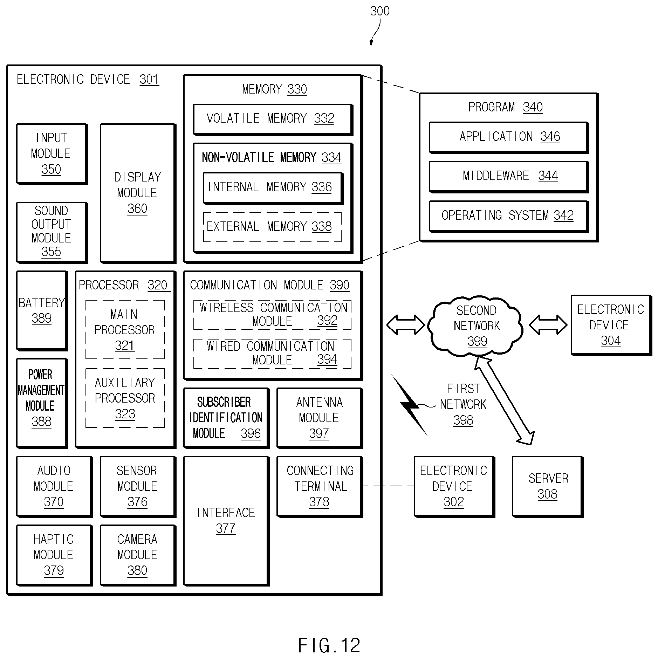

FIG. 12 is a block diagram illustrating an electronic device 301 in a network environment 300 according to various embodiments.

For example, the electronic device 301 of FIG. 12 may be referred to as the electronic device 100 of FIG. 1 or the electronic device 100 of FIG. 2.

Referring to FIG. 12, the electronic device 301 in the network environment 300 may communicate with an electronic device 302 via a first network 398 (e.g., a short-range wireless communication network), or at least one of an electronic device 304 or a server 308 via a second network 399 (e.g., a long-range wireless communication network). According to an embodiment, the electronic device 301 may communicate with the electronic device 304 via the server 308. According to an embodiment, the electronic device 301 may include a processor 320, memory 330, an input module 350, a sound output module 355, a display module 360, an audio module 370, a sensor module 376, an interface 377, a connecting terminal 378, a haptic module 379, a camera module 380, a power management module 388, a battery 389, a communication module 390, a subscriber identification module(SIM) 396, or an antenna module 397. In some embodiments, at least one of the components (e.g., the connecting terminal 378) may be omitted from the electronic device 301, or one or more other components may be added in the electronic device 301. In some embodiments, some of the components (e.g., the sensor module 376, the camera module 380, or the antenna module 397) may be implemented as a single component (e.g., the display module 360).

The processor 320 may execute, for example, software (e.g., a program 340) to control at least one other component (e.g., a hardware or software component) of the electronic device 301 coupled with the processor 320, and may perform various data processing or computation. According to one embodiment, as at least part of the data processing or computation, the processor 320 may store a command or data received from another component (e.g., the sensor module 376 or the communication module 390) in volatile memory 332, process the command or the data stored in the volatile memory 332, and store resulting data in non-volatile memory 334. According to an embodiment, the processor 320 may include a main processor 321 (e.g., a central processing unit (CPU) or an application processor (AP)), or an auxiliary processor 323 (e.g., a graphics processing unit (GPU), a neural processing unit (NPU), an image signal processor (ISP), a sensor hub processor, or a communication processor (CP)) that is operable independently from, or in conjunction with, the main processor 321. For example, when the electronic device 301 includes the main processor 321 and the auxiliary processor 323, the auxiliary processor 323 may be adapted to consume less power than the main processor 321, or to be specific to a specified function. The auxiliary processor 323 may be implemented as separate from, or as part of the main processor 321.

The auxiliary processor 323 may control at least some of functions or states related to at least one component (e.g., the display module 360, the sensor module 376, or the communication module 390) among the components of the electronic device 301, instead of the main processor 321 while the main processor 321 is in an inactive (e.g., sleep) state, or together with the main processor 321 while the main processor 321 is in an active state (e.g., executing an application). According to an embodiment, the auxiliary processor 323 (e.g., an image signal processor or a communication processor) may be implemented as part of another component (e.g., the camera module 380 or the communication module 390) functionally related to the auxiliary processor 323. According to an embodiment, the auxiliary processor 323 (e.g., the neural processing unit) may include a hardware structure specified for artificial intelligence model processing. An artificial intelligence model may be generated by machine learning. Such learning may be performed, e.g., by the electronic device 301 where the artificial intelligence is performed or via a separate server (e.g., the server 308). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 330 may store various data used by at least one component (e.g., the processor 320 or the sensor module 376) of the electronic device 301. The various data may include, for example, software (e.g., the program 340) and input data or output data for a command related thererto. The memory 330 may include the volatile memory 332 or the non-volatile memory 334.

The program 340 may be stored in the memory 330 as software, and may include, for example, an operating system (OS) 342, middleware 344, or an application 346.

The input module 350 may receive a command or data to be used by another component (e.g., the processor 320) of the electronic device 301, from the outside (e.g., a user) of the electronic device 301. The input module 350 may include, for example, a microphone, a mouse, a keyboard, a key (e.g., a button), or a digital pen (e.g., a stylus pen).

The sound output module 355 may output sound signals to the outside of the electronic device 301. The sound output module 355 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 360 may visually provide information to the outside (e.g., a user) of the electronic device 301. The display module 360 may include, for example, a display, a hologram device, or a projector and control circuitry to control a corresponding one of the display, hologram device, and projector. According to an embodiment, the display module 360 may include a touch sensor adapted to detect a touch, or a pressure sensor adapted to measure the intensity of force incurred by the touch.

The audio module 370 may convert a sound into an electrical signal and vice versa. According to an embodiment, the audio module 370 may obtain the sound via the input module 350, or output the sound via the sound output module 355 or a headphone of an external electronic device (e.g., an electronic device 302) directly (e.g., wired) or wirelessly coupled with the electronic device 301.

The sensor module 376 may detect an operational state (e.g., power or temperature) of the electronic device 301 or an environmental state (e.g., a state of a user) external to the electronic device 301, and then generate an electrical signal or data value corresponding to the detected state. According to an embodiment, the sensor module 376 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 377 may support one or more specified protocols to be used for the electronic device 301 to be coupled with the external electronic device (e.g., the electronic device 302) directly (e.g., wired) or wirelessly. According to an embodiment, the interface 377 may include, for example, a high definition multimedia interface (HDMI), a universal serial bus (USB) interface, a secure digital (SD) card interface, or an audio interface.

A connecting terminal 378 may include a connector via which the electronic device 301 may be physically connected with the external electronic device (e.g., the electronic device 302). According to an embodiment, the connecting terminal 378 may include, for example, a HDMI connector, a USB connector, a SD card connector, or an audio connector (e.g., a headphone connector).

The haptic module 379 may convert an electrical signal into a mechanical stimulus (e.g., a vibration or a movement) or electrical stimulus which may be recognized by a user via his tactile sensation or kinesthetic sensation. According to an embodiment, the haptic module 379 may include, for example, a motor, a piezoelectric element, or an electric stimulator.

The camera module 380 may capture a still image or moving images. According to an embodiment, the camera module 380 may include one or more lenses, image sensors, image signal processors, or flashes.

The power management module 388 may manage power supplied to the electronic device 301. According to one embodiment, the power management module 388 may be implemented as at least part of, for example, a power management integrated circuit (PMIC).

The battery 389 may supply power to at least one component of the electronic device 301. According to an embodiment, the battery 389 may include, for example, a primary cell which is not rechargeable, a secondary cell which is rechargeable, or a fuel cell.

The communication module 390 may support establishing a direct (e.g., wired) communication channel or a wireless communication channel between the electronic device 301 and the external electronic device (e.g., the electronic device 302, the electronic device 304, or the server 308) and performing communication via the established communication channel. The communication module 390 may include one or more communication processors that are operable independently from the processor 320 (e.g., the application processor (AP)) and supports a direct (e.g., wired) communication or a wireless communication. According to an embodiment, the communication module 390 may include a wireless communication module 392 (e.g., a cellular communication module, a short-range wireless communication module, or a global navigation satellite system (GNSS) communication module) or a wired communication module 394 (e.g., a local area network (LAN) communication module or a power line communication (PLC) module). A corresponding one of these communication modules may communicate with the external electronic device via the first network 398 (e.g., a short-range communication network, such as Bluetooth^{®}, wireless-fidelity (Wi-Fi) direct, or infrared data association (IrDA)) or the second network 399 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 392 may identify and authenticate the electronic device 301 in a communication network, such as the first network 398 or the second network 399, using subscriber information (e.g., international mobile subscriber identity (IMSI)) stored in the subscriber identification module 396.

The wireless communication module 392 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 392 may support a high-frequency band (e.g., the mmWave band) to achieve, e.g., a high data transmission rate. The wireless communication module 392 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 392 may support various requirements specified in the electronic device 301, an external electronic device (e.g., the electronic device 304), or a network system (e.g., the second network 399). According to an embodiment, the wireless communication module 392 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 397 may transmit or receive a signal or power to or from the outside (e.g., the external electronic device) of the electronic device 301. According to an embodiment, the antenna module 397 may include an antenna including a radiating element composed of a conductive material or a conductive pattern formed in or on a substrate (e.g., a printed circuit board (PCB)). According to an embodiment, the antenna module 397 may include a plurality of antennas (e.g., array antennas). In such a case, at least one antenna appropriate for a communication scheme used in the communication network, such as the first network 398 or the second network 399, may be selected, for example, by the communication module 390 (e.g., the wireless communication module 392) from the plurality of antennas. The signal or the power may then be transmitted or received between the communication module 390 and the external electronic device via the selected at least one antenna. According to an embodiment, another component (e.g., a radio frequency integrated circuit (RFIC)) other than the radiating element may be additionally formed as part of the antenna module 397.

According to various embodiments, the antenna module 397 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 301 and the external electronic device 304 via the server 308 coupled with the second network 399. Each of the electronic devices 302 or 304 may be a device of a same type as, or a different type, from the electronic device 301. According to an embodiment, all or some of operations to be executed at the electronic device 301 may be executed at one or more of the external electronic devices 302, 304, or 308. For example, if the electronic device 301 should perform a function or a service automatically, or in response to a request from a user or another device, the electronic device 301, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 301. The electronic device 301 may provide the outcome, with or without further processing of the outcome, as at least part of a reply to the request. To that end, a cloud computing, distributed computing, mobile edge computing (MEC), or client-server computing technology may be used, for example. The electronic device 301 may provide ultra-low latency services using, e.g., distributed computing or mobile edge computing. In another embodiment, the external electronic device 304 may include an internet-of-things (IoT) device. The server 308 may be an intelligent server using machine learning and/or a neural network. According to an embodiment, the external electronic device 304 or the server 308 may be included in the second network 399. The electronic device 301 may be applied to intelligent services (e.g., smart home, smart city, smart car, or healthcare) based on 5G communication technology or IoT-related technology.

An electronic device according to an embodiment of the disclosure (e.g., the electronic device 100 of FIG. 1 or 2 or the electronic device 301 of FIG. 12) may include an upper structure (e.g., the camera region 190 of FIG. 2 or the upper structure 190 of FIG. 4) that forms at least a portion of an exterior of the electronic device, a sensor module (e.g., the sensor module 120 of FIG. 3 or 4) including a light emitting unit (e.g., the light emitting unit 121 of FIG. 4) and a light receiving unit (e.g., the light receiving unit 122 of FIG. 4) spaced apart from each other on a surface thereof that faces in a first direction (e.g., the -Z direction of FIGS. 3, 4, 6, and 9) and faces the upper structure 190, and a shielding structure (e.g., the shielding structure 180 of FIG. 3, 4, 6, or 8) that has a thin film form and surrounds at least a portion of the surface of the sensor module 120 that faces in the first direction (the -Z direction), the first direction (the -Z direction) being a direction in which the light emitting unit 121 emits light. The upper structure 190 may be spaced apart from a surface of the shielding structure 180 that faces in the first direction (the -Z direction). The shielding structure 180 may include a shielding film layer (e.g., the shielding film layer 182 of FIG. 6), a lusterless layer (e.g., the lusterless layer 184 of FIG. 6), and a diffuse reflection layer (e.g., the diffuse reflection layer 185 of FIG. 4, 6, 8, or 9) stacked on the sensor module 120 in the first direction (the -Z direction). The diffuse reflection layer 185 may be formed of a mixture of a plurality of silica particles (e.g., the silica particles 1851a of FIG. 9) and a binder (e.g., the binder 1851b of FIG. 9) and may include, on a surface of the diffuse reflection layer, a plurality of raised parts (e.g., the raised parts 1851 of FIG. 8 or 9) having a mountain shape, the width of which is decreased in the first direction (the -Z direction).

In an embodiment, the binder 1851b may include a material having higher light transmittance than the silica particles 1851a.

In an embodiment, at least a portion of the shielding structure 180 may be formed on a surface located between the light emitting unit 121 and the light receiving unit 122 of the sensor module 120.

In an embodiment, the plurality of silica particles 1851a may have different shapes and a length of 1 µm to 4 µm.

In an embodiment, the height (e.g., the height h₁ of FIG. 9) of the raised parts 1851 in the first direction (the -Z direction) may range from 1 µm to 3 µm.

In an embodiment, a pitch (e.g., the pitch d₁ of FIG. 9) between the raised parts 1851 adjacent to each other may range from 100 µm to 200 µm.

In an embodiment, a conductive adhesive layer (e.g., the conductive adhesive layer 181 of FIG. 6) including a conductive particle and an adhesive material may be formed on at least a portion of the surface of the sensor module 120, and the shielding film layer (e.g., the shielding film layer 182 of FIG. 6) may be formed on the conductive adhesive layer 181.

In an embodiment, the shielding film layer 182 may include a nano fiber and at least one metal layer.

In an embodiment, a base film layer (e.g., the base film layer 183 of FIG. 6) may be stacked on at least a portion of a surface of the shielding film layer 182 through an adhesive material (e.g., the adhesive layer 183a of FIG. 6), and the lusterless layer 184 may include carbon black and may be formed on the base film layer 183.

In an embodiment, the shielding structure 180 may include a first optical hole (e.g., the first optical hole 186 of FIG. 3 or 4) and a second optical hole (e.g., the second optical hole 187 of FIG. 3 or 4) at least partially formed through the shielding structure in the first direction (the -Z direction), and the first optical hole 186 and the second optical hole 187 may at least partially overlap the light emitting unit 121 and the light receiving unit 122 of the sensor module based on the first direction (e.g., the -Z direction).

In an embodiment, the upper structure 190 may at least partially have light transmittance in a region that at least partially overlaps at least one of the first optical hole 186 or the second optical hole 187 based on the first direction (the -Z direction).

A sensor module according to an embodiment of the disclosure (e.g., the sensor module 120 of FIG. 3 or 4) may include a first surface (e.g., the surface of the sensor module 120 of FIG. 4 that faces in the -Z direction) that forms one surface of the sensor module 120, a light emitting unit (e.g., the light emitting unit 121 of FIG. 4) that is formed on the first surface and that emits light in a first direction (the -Z direction) perpendicular to the first surface, a light receiving unit (e.g., the light receiving unit 122 of FIG. 4) formed on the first surface so as to be spaced apart from the light emitting unit 121, a shielding structure (e.g., the shielding structure 180 of FIG. 3, 4, or 6) that surrounds at least a portion of a surface of the sensor module 120 including at least a portion of the first surface, and a first optical hole (e.g., the first optical hole 186 of FIG. 3 or 4) and a second optical hole (e.g., the second optical hole 187 of FIG. 3 or 4) that are at least partially formed through the shielding structure 180 in the first direction (the -Z direction) and that at least partially overlap the light receiving unit 122 and the light emitting unit 121 based on the first direction (the -Z direction). The shielding structure 180 may include a shielding film layer (e.g., the shielding film layer 182 of FIG. 6), a lusterless layer (e.g., the lusterless layer 184 of FIG. 6), and a diffuse reflection layer (e.g., the diffuse reflection layer 185 of FIG. 4, 6, 8, or 9) stacked in the first direction (the -Z direction). The diffuse reflection layer 185 may include a plurality of silica particles (e.g., the silica particles 1851a of FIG. 9) and a binder (e.g., the binder 1851b of FIG. 9) having higher light transmittance than the silica particles 1851a and may include, on at least a portion of a surface located between the first optical hole 186 and the second optical hole 187, a plurality of raised parts (e.g., the raised parts 1851 of FIG. 8 or 9) having a shape, the width of which is decreased in the first direction (the -Z direction).

In an embodiment, the plurality of silica particles 1851a may have different shapes and a length of 1 µm to 4 µm.

In an embodiment, the height (e.g., the height h₁ of FIG. 9) of the raised parts 1851 in the first direction (the -Z direction) may range from 1 µm to 3 µm.

In an embodiment, a pitch (e.g., the pitch d₁ of FIG. 9) between the raised parts 1851 adjacent to each other may range from 100 µm to 200 µm.

In an embodiment, a conductive adhesive layer (e.g., the conductive adhesive layer 181 of FIG. 6) including a conductive particle and an adhesive material may be formed on at least a portion of the surface of the sensor module 120, and the shielding film layer 182 may be formed on the conductive adhesive layer 181.

In an embodiment, the conductive adhesive layer 181 may electrically connect the shielding film layer 182 and the sensor module 120.

A method for forming a shielding structure (e.g., the shielding structure 180 of FIG. 3, 4, or 6) on a sensor module (e.g., the sensor module 120 of FIG. 3 or 4) according to an embodiment of the disclosure may include stacking a conductive adhesive layer (e.g., the conductive adhesive layer 181 of FIG. 6) on at least a portion of a surface of the sensor module 120 (e.g., operation 1010 of FIG. 7), stacking a shielding film layer (e.g., the shielding film layer 182 of FIG. 6) including a nano fiber and a metallic material on the conductive adhesive layer 181 (e.g., operation 1020 of FIG. 7), coating the shielding film layer 182 with a lusterless layer (e.g., the lusterless layer 184 of FIG. 6) (e.g., operation 1040 of FIG. 7), and coating the lusterless layer 184 with a diffuse reflection layer (e.g., the diffuse reflection layer 185 of FIG. 4, 6, 8, or 9) including a silica mixture composed of a silica particle (e.g., the silica particle 1851a of FIG. 9) and a binder (e.g., the binder 1851b of FIG. 9) having higher light transmittance than the silica particle 1851a (e.g., operation 1050 of FIG. 7).

In an embodiment, the coating of the lusterless layer with the diffuse reflection layer 185 may include coating at least a portion of a surface of the diffuse reflection layer 185 with a plurality of raised parts (e.g., the raised parts 1851 of FIG. 8 or 9).

In an embodiment, the coating of the shielding film layer with the lusterless layer 184 may include stacking a base film layer (e.g., the base film layer 183 of FIG. 6) on the shielding film layer 182 (e.g., operation 1050 of FIG. 7) and coating the base film layer 183 with a coating material including carbon black.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 340) including one or more instructions that are stored in a storage medium (e.g., internal memory 336 or external memory 338) that is readable by a machine (e.g., the electronic device 301). For example, a processor (e.g., the processor 320) of the machine (e.g., the electronic device 301) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
an upper structure (190) configured to form at least a portion of an exterior of the electronic device;
a sensor module (120) including a light emitting unit (121) and a light receiving unit (122) spaced apart from each other on a first surface of the sensor module (120), wherein the first surface is configured to face each other with the upper structure (190) in a first direction, wherein the first direction is a direction in which the light emitting unit (121) emits light; and
a shielding structure (180) having a film form disposed on a portion of the first surface of the sensor module (120) and including an upper surface, and a lower surface in contact with the first surface of the sensor module (120); and,
a first optical hole (186) and a second optical hole (187) at least partially formed from the upper surface to lower surface of the shielding structure (180) in the first direction,
wherein light emitted by the light emitting unit (121) passes through the first optical hole (186) and light incident toward the light receiving unit (122) passes through the second optical hole (187),
wherein the upper structure (190) is spaced apart from a surface of the shielding structure (180) facing in the first direction,
wherein the shielding structure (180) includes a shielding film layer (182), a lusterless layer (184), and a diffuse reflection layer (185) stacked on the sensor module (120) in the first direction, and
wherein the diffuse reflection layer (185) is formed of a mixture of a plurality of silica particles (1851a) and a binder (1851b) on the lusterless layer (184) and includes, on a surface of the diffuse reflection layer (185), a plurality of raised parts (1851) having a mountain shape, the width of which is decreased in the first direction.

2. The electronic device of claim 1, wherein the binder (1851b) includes a material having higher light transmittance than the silica particles (1851a).

3. The electronic device of any one of claim 1 or 2, wherein at least a portion of the shielding structure (180) is formed on a surface located between the light emitting unit and the light receiving unit of the sensor module (120).

4. The electronic device of any one of the preceding claims, wherein the plurality of silica particles (1851a) have different shapes and a length of 1 µm to 4 µm.

5. The electronic device of any one of the preceding claims, wherein the raised parts have a height of 1 µm to 3 µm in the first direction.

6. The electronic device of any one of the preceding claims, wherein a pitch between the raised parts (1851) adjacent to each other ranges from 100 µm to 200 µm.

7. The electronic device of any one of the preceding claims, wherein a conductive adhesive layer including a conductive particle and an adhesive material is formed on at least a portion of the surface of the sensor module (120), and
wherein the shielding film layer (182) is formed on the conductive adhesive layer.

8. The electronic device of any one of the preceding claims, wherein the shielding film layer (182) includes a nano fiber and at least one metal layer.

9. The electronic device of any one of the preceding claims, wherein a base film layer is stacked on at least a portion of a surface of the shielding film layer (182) through an adhesive material, and
wherein the lusterless layer includes carbon black and is formed on the base film layer.

10. The electronic device of claim 1,
wherein the first optical hole and the second optical hole at least partially overlap the light emitting unit and the light receiving unit of the sensor module (120) based on the first direction.

11. The electronic device of claim 10, wherein the upper structure (190) at least partially has light transmittance in a region configured to at least partially overlap at least one of the first optical hole or the second optical hole based on the first direction.

## Patentansprüche

1. Elektronische Vorrichtung, die Folgendes umfasst:
eine obere Struktur (190), die so konfiguriert ist, dass sie mindestens einen Teil einer Außenseite der elektronischen Vorrichtung bildet;
ein Sensormodul (120), das eine lichtemittierende Einheit (121) und eine Lichtempfangseinheit (122) enthält, die auf einer ersten Oberfläche des Sensormoduls (120) voneinander beabstandet sind, wobei die erste Oberfläche so konfiguriert ist, dass sie der oberen Struktur (190) in einer ersten Richtung zugewandt ist, wobei die erste Richtung eine Richtung ist, in die die lichtemittierende Einheit (121) Licht emittiert; und
eine Abschirmstruktur (180), die eine auf einem Teil der ersten Oberfläche des Sensormoduls (120) angeordnete Folienform aufweist und eine Oberseite und eine Unterseite enthält, die mit der ersten Oberfläche des Sensormoduls (120) in Kontakt steht; und
ein erstes optisches Loch (186) und ein zweites optisches Loch (187), die zumindest teilweise von der Oberseite zur Unterseite der Abschirmstruktur (180) in der ersten Richtung ausgebildet sind,
wobei das von der lichtemittierenden Einheit (121) emittierte Licht durch das erste optische Loch (186) hindurchgeht und das auf die Lichtempfangseinheit (122) einfallende Licht durch das zweite optische Loch (187) hindurchgeht,
wobei die obere Struktur (190) von einer Oberfläche der Abschirmstruktur (180) beabstandet ist, die in die erste Richtung zeigt,
wobei die Abschirmstruktur (180) eine Abschirmfolienschicht (182), eine glanzlose Schicht (184) und eine diffuse Reflexionsschicht (185) enthält, die in der ersten Richtung auf dem Sensormodul (120) gestapelt sind, und
wobei die diffuse Reflexionsschicht (185) aus einer Mischung aus einer Vielzahl von Silica-Partikeln (1851a) und einem Bindemittel (1851b) auf der glanzlosen Schicht (184) ausgebildet ist und auf einer Oberfläche der diffusen Reflexionsschicht (185) eine Vielzahl von erhöhten Teilen (1851) enthält, die eine Bergform aufweisen, deren Breite in der ersten Richtung abnimmt.

2. Elektronische Vorrichtung nach Anspruch 1, wobei das Bindemittel (1851b) ein Material mit höherer Lichtdurchlässigkeit als die Silica-Partikel (1851a) enthält.

3. Elektronische Vorrichtung nach einem der Ansprüche 1 oder 2, wobei mindestens ein Teil der Abschirmstruktur (180) auf einer Oberfläche ausgebildet ist, die sich zwischen der lichtemittierenden Einheit und der Lichtempfangseinheit des Sensormoduls (120) befindet.

4. Elektronische Vorrichtung nach einem der vorhergehenden Ansprüche, wobei die Vielzahl von Silica-Partikeln (1851a) unterschiedliche Formen und eine Länge von 1 µm bis 4 µm aufweisen.

5. Elektronische Vorrichtung nach einem der vorhergehenden Ansprüche, wobei die erhöhten Teile in der ersten Richtung eine Höhe von 1 µm bis 3 µm aufweisen.

6. Elektronische Vorrichtung nach einem der vorhergehenden Ansprüche, wobei eine Steigung zwischen den aneinandergrenzenden erhöhten Teilen (1851) zwischen 100 µm und 200 µm liegt.

7. Elektronische Vorrichtung nach einem der vorhergehenden Ansprüche, wobei auf mindestens einem Teil der Oberfläche des Sensormoduls (120) eine leitfähige Klebeschicht ausgebildet ist, die ein leitfähiges Partikel und ein Klebematerial enthält, und
wobei die Abschirmfolienschicht (182) auf der leitfähigen Klebeschicht ausgebildet ist.

8. Elektronische Vorrichtung nach einem der vorhergehenden Ansprüche, wobei die Abschirmfolienschicht (182) eine Nanofaser und mindestens eine Metallschicht enthält.

9. Elektronische Vorrichtung nach einem der vorhergehenden Ansprüche, wobei eine Basisfolienschicht durch ein Klebematerial auf mindestens einen Teil einer Oberfläche der Abschirmfolienschicht (182) gestapelt ist, und
wobei die glanzlose Schicht Ruß enthält und auf der Basisfolienschicht ausgebildet ist.

10. Elektronische Vorrichtung nach Anspruch 1,
wobei das erste optische Loch und das zweite optische Loch die lichtemittierende Einheit und die Lichtempfangseinheit des Sensormoduls (120) basierend auf der ersten Richtung zumindest teilweise überlappen.

11. Elektronische Vorrichtung nach Anspruch 10, wobei die obere Struktur (190) zumindest teilweise eine Lichtdurchlässigkeit in einem Bereich aufweist, der so konfiguriert ist, dass er das erste optische Loch und/oder das zweite optische Loch basierend auf der ersten Richtung zumindest teilweise überlappt.

## Revendications

1. Dispositif électronique comprenant :
une structure supérieure (190) configurée pour former au moins une partie de l'extérieur du dispositif électronique ;
un module de capteur (120) incluant une unité d'émission de lumière (121) et une unité de réception de lumière (122) espacées l'une de l'autre sur une première surface du module de capteur (120), où la première surface est configurée pour faire face à la structure supérieure (190) dans une première direction, où la première direction est une direction dans laquelle l'unité d'émission de lumière (121) émet de la lumière ; et
une structure de blindage (180) ayant une forme de film disposée sur une partie de la première surface du module de capteur (120) et incluant une surface supérieure et une surface inférieure en contact avec la première surface du module de capteur (120) ; et,
un premier trou optique (186) et un deuxième trou optique (187) formés au moins partiellement depuis la surface supérieure vers la surface inférieure de la structure de blindage (180) dans la première direction,
où la lumière émise par l'unité d'émission de lumière (121) passe à travers le premier trou optique (186) et la lumière incidente vers l'unité de réception de lumière (122) passe à travers le deuxième trou optique (187),
où la structure supérieure (190) est espacée d'une surface de la structure de blindage (180) orientée dans la première direction,
où la structure de blindage (180) inclut une couche de film de blindage (182), une couche mate (184) et une couche de réflexion diffuse (185) empilées sur le module de capteur (120) dans la première direction, et
où la couche de réflexion diffuse (185) est formée d'un mélange d'une pluralité de particules de silice (1851a) et d'un liant (1851b) sur la couche mate (184) et inclut, sur une surface de la couche de réflexion diffuse (185), une pluralité de parties surélevées (1851) ayant une forme de montagne, dont la largeur est réduite dans la première direction.

2. Dispositif électronique selon la revendication 1, où le liant (1851b) inclut un matériau ayant une transmittance de lumière supérieure à celle des particules de silice (1851a).

3. Dispositif électronique selon l'une quelconque des revendications 1 ou 2, où au moins une partie de la structure de blindage (180) est formée sur une surface située entre l'unité d'émission de lumière et l'unité de réception de lumière du module de capteur (120).

4. Dispositif électronique selon l'une quelconque des revendications précédentes, où la pluralité de particules de silice (1851a) a des formes différentes et une longueur comprise de 1 µm à 4 µm.

5. Dispositif électronique selon l'une quelconque des revendications précédentes, où les parties surélevées ont une hauteur de 1 µm à 3 µm dans la première direction.

6. Dispositif électronique selon l'une quelconque des revendications précédentes, où un pas entre les parties surélevées (1851) adjacentes les unes aux autres est compris entre 100 µm et 200 µm.

7. Dispositif électronique selon l'une quelconque des revendications précédentes, où une couche adhésive conductrice incluant une particule conductrice et un matériau adhésif est formée sur au moins une partie de la surface du module de capteur (120), et
où la couche de film de blindage (182) est formée sur la couche adhésive conductrice.

8. Dispositif électronique selon l'une quelconque des revendications précédentes, où la couche de film de blindage (182) inclut une nano fibre et au moins une couche métallique.

9. Dispositif électronique selon l'une quelconque des revendications précédentes, où une couche de film de base est empilée sur au moins une partie d'une surface de la couche de film de blindage (182) par l'intermédiaire d'un matériau adhésif, et
où la couche mate inclut du noir de carbone et est formée sur la couche de film de base.

10. Dispositif électronique selon la revendication 1,
où le premier trou optique et le deuxième trou optique chevauchent au moins partiellement l'unité d'émission de lumière et l'unité de réception de lumière du module de capteur (120) sur la base de la première direction.

11. Dispositif électronique selon la revendication 10, où la structure supérieure (190) présente au moins partiellement une transmittance de lumière dans une région configurée pour chevaucher au moins partiellement au moins l'un parmi le premier trou optique ou le deuxième trou optique sur la base de la première direction.
